# EUROPEAN PATENT APPLICATION

(11) **EP 4 687 136 A2**
(43) Date of publication of application: **04.02.2026**
(21) Application number: 25193205.9
(22) Date of filing: 31.07.2025
(51) Int. Cl.: G09G 3/3233

(54) **DISPLAY DEVICE AND ELECTRONIC DEVICE INCLUDING THE SAME**

(30) Priority: 31.07.2024 KR 20240101919
(71) Applicant: Samsung Display Co., Ltd., Yongin-si, Gyeonggi-do 17113 (KR)
(72) Inventor: KIM, SUNGHWAN, 17113 Yongin-si (KR); LEE, SOYOUNG, 17113 Yongin-si (KR)
(74) Representative: Taor, Simon Edward William

(57) **Abstract**

A display device includes a pixel including a light emitting element, first to fourth transistors, a storage capacitor, and first and second boost capacitors. The first transistor is connected between the light emitting element and a first driving voltage line, operates based on a potential at a first node, and the second transistor is connected to a data line, a first electrode of the first transistor, and a first scan line. The third transistor is connected to the first node, a second electrode of the first transistor, and a second scan line. The storage capacitor is connected between the first node and a first driving voltage line, the first boost capacitor is connected between the first node and the first scan line, and the second boost capacitor is connected between the first node and the second scan line.

## Description

### BACKGROUND

### 1. Technical Field

Embodiments of the disclosure described herein relate to a display device and an electronic device including the display device, and more particularly, relate to a display device having a higher resolution and an electronic device including the display device.

### 2. Description of the Related Art

An emissive-type display device among display devices displays an image by using a light emitting diode that generates a light through the recombination of electrons and holes. The emissive-type display device has a rapid response speed and is driven with lower power consumption.

The emissive-type display device includes a display panel including pixels electrically connected to data lines and scan lines. Each pixel typically includes a light emitting diode and a circuit unit to control an amount of current flowing through the light emitting diode. In response to the data signal, a pixel circuit unit controls an amount of current flowing at a second driving voltage after flowing through a light emitting diode at a first driving voltage. For example, light having a specific brightness is generated to correspond to the amount of current flowing through the light emitting diode.

### SUMMARY

Embodiments of the disclosure provide a display device capable of reducing power consumption with a higher resolution and an electronic device including the same.

According to an embodiment of the disclosure, a display device includes a display panel including a pixel. The pixel includes a light emitting element, a first transistor connected between the light emitting element and a first driving voltage line, and the first transistor that operates based on a potential at a first node, a second transistor connected between a data line and a first electrode of the first transistor, and the second transistor that receives a first scan signal through a first scan line, a third transistor connected between the first node and a second electrode of the first transistor, and the third transistor that receives a second scan signal through a second scan line, a fourth transistor connected between the first node and a first initializing voltage line, and the fourth transistor that receives a third scan signal through a third scan line, a storage capacitor between the first node and the first driving voltage line, a first boost capacitor between the first node and the first scan line, and a second boost capacitor between the first node and the second scan line.

The second boost capacitor may include: a first sub-boost capacitor and a second sub-boost capacitor connected in series between the first node and the second scan line.

The third transistor may include: a first sub-transistor connected between the first node and a first coupling node, and the first sub-transistor that receives the second scan signal through the second scan line; and a second sub-transistor connected between the first coupling node and the second electrode of the first transistor, and the second sub-transistor that receives the second scan signal through the second scan line.

The pixel may further include: a first node capacitor connected between the first coupling node and the first driving voltage line.

The fourth transistor may include: a third sub-transistor connected between the first node and a second coupling node, and the third sub-transistor that receives the third scan signal through the third scan line; and a fourth sub-transistor connected between the second coupling node and the first initializing voltage line, and the fourth sub-transistor that receives the third scan signal through the third scan line.

The pixel may further include: a second node capacitor connected between the second coupling node and the first initializing voltage line.

The first scan signal may be activated during a data write period, the second scan signal may be activated during a compensating period, the data write period and the compensating period may overlap each other, each of the data write period and the compensating period may be a low level period, and a terminating time point of the compensating period may be the same as or follows a terminating time point of the data write period.

The pixel may further include: a fifth transistor connected between the first electrode of the first transistor and the first driving voltage line, and the fifth transistor that receives a light emitting control signal through a light emitting control line; a sixth transistor connected between the second electrode of the first transistor and the light emitting element, and the sixth transistor that receives the light emitting control signal through the light emitting control line; a seventh transistor connected between the light emitting element and a second initializing voltage line, and the seventh transistor that receives a fourth scan signal through a fourth scan line; and an eighth transistor connected between the first electrode of the first transistor and a bias voltage line, and the eight transistor that receives the fourth scan signal through the fourth scan line, and each of the first, second, third, fourth, fifth, sixth, seventh, and eighth transistors may be a low-temperature polycrystalline silicon (LTPS) transistor.

According to an embodiment of the disclosure, a display device includes an element layer including a light emitting element, and a circuit layer including a pixel circuit unit connected to the light emitting element, The circuit layer includes a first transistor including a gate electrode connected to a first node, a first electrode connected to a second node, and a second electrode connected to a third node, a second transistor including a gate electrode connected to a first scan line, a first electrode connected to a data line, and a second electrode connected to the second node, a third transistor including a gate electrode connected to a second scan line, a first electrode connected to the third node, and a second electrode connected to the first node, a fourth transistor including a gate electrode connected to a third scan line, a first electrode connected to the first node, and the second electrode connected to a first initializing voltage line, a first capacitor electrode extending from the gate electrode of the first transistor, a second capacitor electrode that faces the first capacitor electrode to form a storage capacitor, and connected to a first driving voltage line, and an additional gate electrode connected to the gate electrode of the first transistor and overlapping the first scan line to form a first boost capacitor. The additional gate electrode is disposed on a layer different from a layer for the gate electrode of the first transistor, the second capacitor electrode, and the first scan line.

The circuit layer may further include: a first insulating layer; a first gate pattern layer disposed on the first insulating layer, and including the gate electrodes of the first, second, third, and fourth transistors and the first capacitor electrode; a second insulating layer to cover the first gate pattern layer; a second gate pattern layer disposed on the second insulating layer, and including the second capacitor electrode; a third insulating layer to cover the second gate pattern layer; and a third gate pattern layer disposed on the third insulating layer, and including the additional gate electrode.

The circuit layer may further include: an auxiliary scan line connected to the second scan line through at least two contact holes, and the auxiliary scan line is disposed on the first insulating layer and included in the first gate pattern layer.

The circuit layer may further include: a fourth insulating layer to cover the third gate pattern layer; and a first data pattern layer disposed on the fourth insulating layer, and including the first, second, and third scan lines and a horizontal voltage line, and the additional gate electrode overlaps the second scan line to form a first sub-boost capacitor, and overlaps the auxiliary scan line to form a second sub-boost capacitor.

The circuit layer may further include: a fifth insulating layer to cover the first data pattern layer, and a second data pattern layer disposed on the fifth insulating layer, and including the data line and a vertical voltage line, and the vertical voltage line is connected to the horizontal voltage line to form the first driving voltage line.

The third transistor may include: a first sub-transistor including a gate electrode connected to the second scan line, a first electrode connected to a first coupling node, and a second electrode connected to the first node; and a second sub-transistor including a gate electrode connected to the second scan line, a first electrode connected to the third node, and a second electrode connected to the first coupling node.

The circuit layer may further include: a semiconductor pattern layer including channel parts of the first, second, third, and fourth transistors, and the first and second electrodes of the first, second, third, and fourth transistors, and the semiconductor pattern layer further includes a first node capacitor electrode corresponding to the first coupling node.

The circuit layer may further include: a first insulating layer to cover the semiconductor pattern layer; a first gate pattern layer disposed on the first insulating layer, and including the gate electrodes of the first to fourth transistors and the first capacitor electrode; a second insulating layer to cover the first gate pattern layer; a second gate pattern layer disposed on the second insulating layer, and including the second capacitor electrode and a second node capacitor electrode which branches from the second capacitor electrode and overlaps the first node capacitor electrode; a third insulating layer to cover the second gate pattern layer; and a third gate pattern layer disposed on the third insulating layer, and including the additional gate electrode, and the additional gate electrode is a non-overlapping with the second node capacitor electrode in a plan view.

The fourth transistor may include: a third sub-transistor including a gate electrode connected to the third scan line, a first electrode connected to the first node, and a second electrode connected to a second coupling node; and a fourth sub-transistor including a gate electrode connected to the third scan line, a first electrode connected to the first initializing voltage line, and a second electrode connected to the second coupling node.

The circuit layer may further include a semiconductor pattern layer including channel parts of the first, second, third, and fourth transistors and the first and second electrodes of the first, second, third, and fourth transistors, and the semiconductor pattern layer further includes a third node capacitor electrode corresponding to the second coupling node.

The circuit layer may further include: a first insulating layer to cover the semiconductor pattern layer; a first gate pattern layer disposed on the first insulating layer, and including the gate electrodes of the first, second, third, and fourth transistors and the first capacitor electrode; a second insulating layer to cover the first gate pattern layer; a second gate pattern layer disposed on the second insulating layer, and including a fourth node capacitor electrode overlapping the third node capacitor electrode, and the second capacitor electrode; a third insulating layer to cover the second gate pattern layer; and a third gate pattern layer disposed on the third insulating layer, and including the additional gate electrode, and the additional gate electrode is a non-overlapping state with the fourth node capacitor electrode in a plan view.

According to an embodiment of the disclosure, an electronic device includes a display panel including a pixel, a panel driver that drives the display panel, and a main processor that provides an image signal to the panel driver. The pixel includes a light emitting element, a first transistor connected between the light emitting element and a first driving voltage line, and the first transistor that operates based on a potential at a first node, a second transistor connected between a data line and a first electrode of the first transistor, and the second transistor that receives a first scan signal through a first scan line, a third transistor connected between the first node and a second electrode of the first transistor, and the third transistor that receives a second scan signal through a second scan line, a fourth transistor connected between the first node and a first initializing voltage line, and the fourth transistor that receives a third scan signal through a third scan line, a storage capacitor between the first node and the first driving voltage line, a first boost capacitor between the first node and the first scan line, and a second boost capacitor between the first node and the second scan line.

According to an aspect, there is provided a display device as set out in claim 1. Additional features are set out in claims 2 to 8. According to an aspect, there is provided a display device as set out in claim 9. Additional features are set out in claims 10 to 14. According to an aspect, there is provided an electronic device as set out in claim 15.

### BRIEF DESCRIPTION OF THE DRAWINGS

The above and other objects and features of the disclosure will become apparent by describing in detail embodiments thereof with reference to the accompanying drawings.
FIG. 1 is a schematic perspective view illustrating a display device according to an embodiment of the disclosure.
FIG. 2 is an exploded schematic perspective view of a display device according to an embodiment of the disclosure.
FIG. 3 is a schematic block diagram of a display device according to an embodiment of the disclosure.
FIGS. 4A, 4B, 4C, and 4D are schematic plan views illustrating the arrangement of light emitting element units according to an embodiment of the disclosure.
FIG. 5 is a schematic diagram of an equivalent circuit according to an embodiment of the disclosure.
FIGS. 6A and 6B are timing diagrams for describing an operation of a pixel according to an embodiment of the disclosure.
FIG. 7 is a schematic cross-sectional view illustrating a portion of a display panel according to an embodiment of the disclosure.
FIG. 8 is a schematic plan view illustrating a portion of a display panel according to an embodiment of the disclosure.
FIGS. 9A, 9B, 9C, 9D, 9E, 9F, and 9G are schematic plan views illustrating the layout for each of layers stacked on a display panel.
FIG. 10 is a schematic block diagram of an electronic device according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on,'' "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z-axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art. For example, "about" may mean within one or more standard deviations, or within ±20%, ±10%, or ±5% of the stated value.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the disclosure. Further, the blocks, units, and/or modules of some embodiments may be physically combined into more complex blocks, units, and/or modules without departing from the scope of the disclosure.

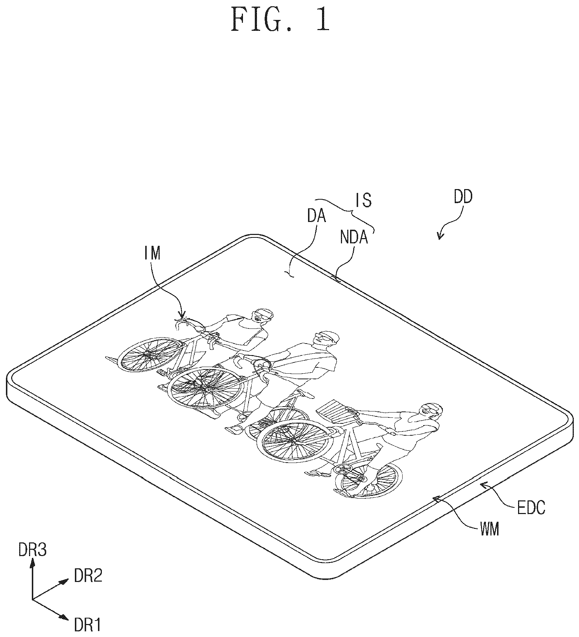

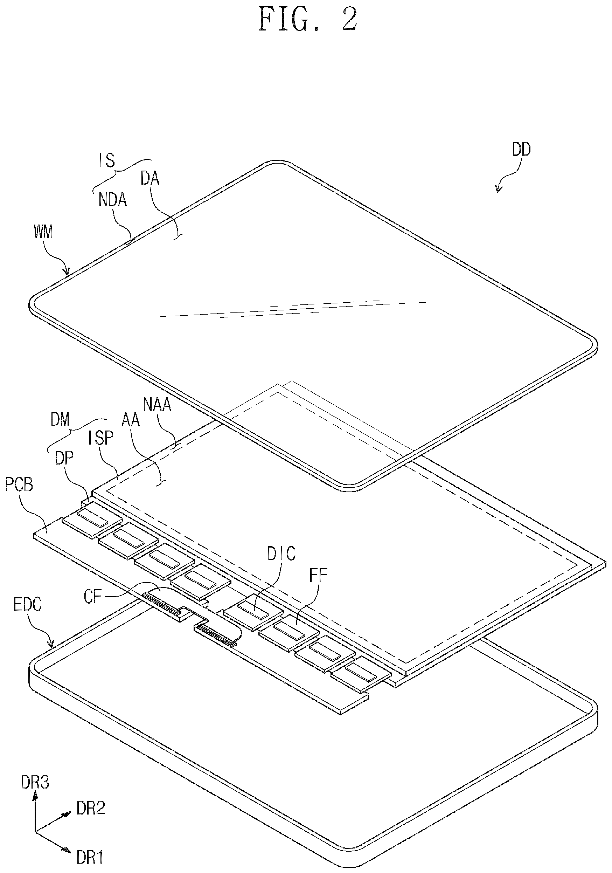

FIG. 1 is a schematic perspective view of a display device according to an embodiment of the disclosure, and FIG. 2 is an exploded schematic perspective view of a display device according to an embodiment of the disclosure.

Referring to FIGS. 1 and 2, a display device DD may be a device activated in response to an electrical signal. According to the disclosure, the display device DD may include a larger-size display device, such as a television or a monitor, or a smaller or medium-size display device, such as a cellular phone, a tablet PC, a laptop computer, a vehicle navigation, or a game machine. The display devices may be provided only for the illustrative purpose. It is obvious that the display device DD may be implemented in another form without departing from the scope of the disclosure. The display device DD has a rectangular shape having a longer side extending in a first direction DR1, and a shorter side extending in a second direction DR2 crossing the first direction DR1. However, the shape of the display device DD is not limited thereto, but various display devices DD having various shapes may be provided. The display device DD may display an image IM, in a third direction DR3, on a display surface IS parallel to the first direction DR1 and the second direction DR2. The display surface IS to display the image IM may correspond to a front surface of the display device DD.

A front surface (or top surfaces) and a rear surface (or bottom surfaces) of members are defined based on a direction that the image IM is displayed. The front surface and the rear surface may be opposite to each other in the third direction DR3, and the normal direction of each of the front surface and the rear surface may be parallel to the third direction DR3.

A distance between the front surface and the rear surface in the third direction DR3 may correspond to a thickness of the display device DD in the third direction DR3. Meanwhile, directions that the first, second, and third directions DR1, DR2, and DR3 indicate may be relative in concept and may be changed to different directions.

The display device DD may sense an external input applied from the outside. The external input may include various types of inputs which are provided from the outside of the display device DD. The display device DD may sense an external input of the user, which is applied from the outside. The external input of the user may include any one of various external inputs, such as a part of a body of the user, light, heat, or pressure, or the combination thereof. The display device DD may sense the external input of the user, which is applied to the side surface or the rear surface of the display device DD based on the structures of the display device DD, and is not limited thereto. The external input may include an input (for example, a stylus pen, an active pen, a touch pen, an electronic pen, or an e-pen).

The display surface IS of the display device DD may be divided into a display region DA and a non-display region NDA. The display region DA may be a region for displaying the image IM. The user views the image IM through the display region DA. According to the present embodiment, the display region DA is illustrated as a rectangular shape rounded in vertexes. However, embodiments are not particularly limited thereto. The display region DA may have various shapes, and not limited thereto.

The non-display region NDA may be disposed adjacent to the display region DA. The non-display region NDA may have a specific color. The non-display region NDA may surround the display region DA. Accordingly, a shape of the display region DA may be defined actually by the non-display region NDA. However, the non-display region NDA may be disposed to be disposed adjacent to only one side of the display region DA or may be omitted. The display device DD may include various embodiments, and not limited thereto.

As illustrated in FIG. 2, the display device DD may include a display module DM and a window WM disposed on or over the display module DM. The display module DM may include a display panel DP and an input sensing layer ISP.

The display panel DP according to an embodiment of the disclosure may be a light emitting display panel. For example, the display panel DP may be an organic light emitting display panel, an inorganic light emitting display panel, or a quantum dot light emitting display panel. A light emitting layer of the organic light emitting display panel may include an organic light emitting material. A light emitting layer of the inorganic light emitting display panel may include an inorganic light emitting material. A light emitting layer of the quantum dot light emitting display panel may include a quantum dot and a quantum rod.

The display panel DP may output the image IM, and the output image IM may be displayed through the display surface IS.

The input sensing layer ISP may be disposed on the display panel DP to sense an external input. The input sensing layer ISP may be disposed (or directly disposed) on the display panel DP. The input sensing layer ISP may be formed on the display panel DP through subsequent processes. In another embodiment, in case that the input sensing layer ISP is disposed (or directly disposed) on the display panel DP, an internal adhesive film (not illustrated) is not interposed between the input sensing layer ISP and the display panel DP. However, the inner adhesive film may be disposed between the input sensing layer ISP and the display panel DP. For example, the input sensing layer ISP and the display panel DP are not fabricated through the subsequent processes. In another embodiment, after fabricating the input sensing layer ISP through a process separate from that of the display panel DP, the input sensing layer ISP may be fixed on a top surface of the display panel DP through the inner adhesive film.

The window WM may be formed of a transparent material for outputting the image IM. For example, the window WM may include glass, sapphire, or plastic. Although the window WM is illustrated in a single layer, embodiments of the disclosure are not limited thereto. For example, the window WM may include multiple layers.

Meanwhile, although not illustrated, the non-display region NDA of the display device DD described above may be provided as a region obtained as a material including a specific color is substantially printed on one region of the window WM. The window WM may include a light blocking pattern to define the non-display region NDA. The light blocking pattern serving as an organic layer having a color may be formed, for example, in a coating scheme.

The window WM may be coupled to the display module DM by an adhesive film. The adhesive film may include an optically clear adhesive film (OCA). However, the adhesive film is not limited thereto, but may include a typical adhesive agent and adhesion agent. For example, the adhesive film may include optically clear resin (OCR), or a pressure sensitive adhesive film (PSA).

An anti-reflective layer may be further interposed between the window WM and the display module DM. The anti-reflective layer decreases the reflectance of an external light incident from above the window WM. The anti-reflective layer may include a phase retarder and a polarizer. The phase retarder may be implemented in a film type or a liquid crystal coating type and may include a λ/2 phase retarder and/or a λ/4 phase retarder. The polarizer may be provided in a film type or a liquid crystal coating type. The film type polarizer may include a stretched synthetic resin film, and the liquid crystal coating type polarizer may include liquid crystals arranged in a specific array. The phase retarder and the polarizer may be implemented in the form of one polarization film.

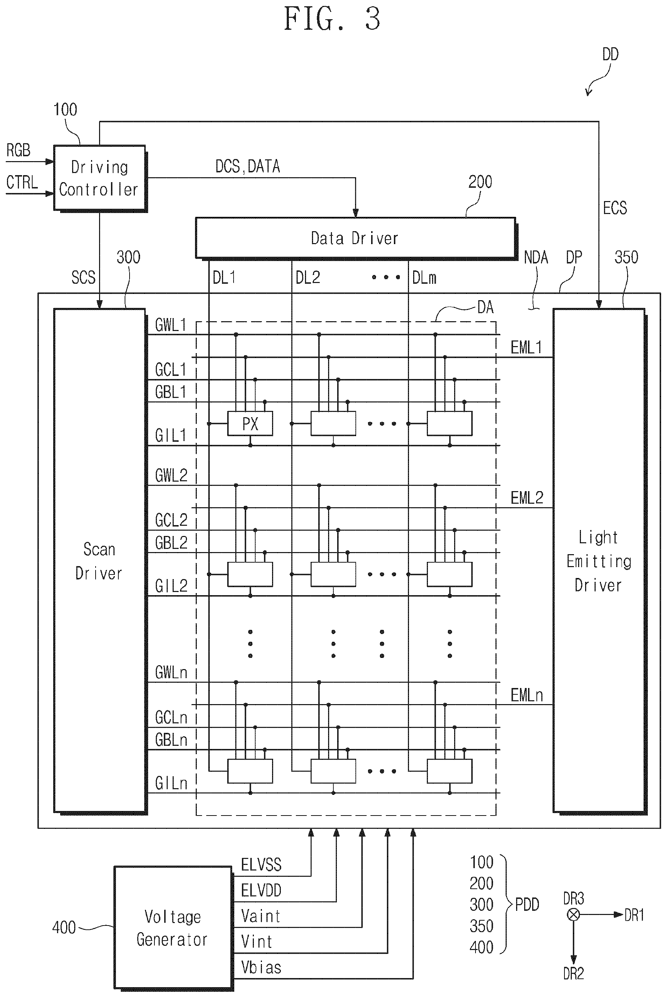

The anti-reflective layer may include color filters. The arrangement of the color filters may be determined based on colors of light generated from multiple pixels PX (see FIG. 3) included in the display panel DP. For example, the anti-reflective layer may further include the light blocking pattern interposed between color filters.

The display module DM may display the image IM, and may transmit/receive information on an external input, in response to an electrical signal. The display module DM may be defined with an active region AA and a non-active region NAA. The active region AA may be a region (e.g., a region to display the image IM) defined to output the image IM from the display panel DP. The active region AA may be defined as a region for the input sensing layer ISP to sense the external input applied from the outside. The active region AA of the display module DM may correspond to at least a portion of the display region DA.

The non-active region NAA may be disposed adjacent to the active region AA. The non-active region NAA may be a region in which the image IM is not displayed actually. For example, the non-active region NAA may surround the active region AA. However, the non-active region NAA may have various forms, and not limited thereto. The non-active region NAA of the display module DM may correspond to at least a portion of the non-display region NDA.

The display device DD may further include multiple flexible films FF connected to the display panel DP. A driving chip DIC may be mounted on each of the flexible films FF. According to an embodiment of the disclosure, a data driver 200 (see FIG. 3) may include multiple driving chips DIC, and multiple driving chips DIC may be mounted on multiple flexible films FF, respectively.

The display device DD may further include at least one printed circuit board PCB coupled to multiple flexible films FF. According to an embodiment of the disclosure, although two printed circuit boards PCB are provided in the display device DD, the number of printed circuit boards PCB is not limited thereto. Two printed circuit boards disposed adjacent to each other from among the printed circuit boards PCB may be electrically connected to each other by a connecting film CF. At least one of the printed circuit boards PCB may be electrically connected to a main board. A driving controller 100 (see FIG. 3) and a voltage generator 400 (see FIG. 3) may be disposed on at least one of the printed circuit boards PCB.

Although FIG. 2 illustrates a structure in which the driving chips DIC are mounted on the flexible films FF, embodiments of the disclosure are not limited thereto. For example, the driving chips DIC may be directly mounted on the display panel DP. For example, a portion, on which the driving chip DIC is mounted, of the display panel DP may be bent such that the driving chip DIC is disposed on the rear surface of the display module DM.

The input sensing layer ISP may be electrically connected to the printed circuit board PCB through multiple flexible films FF. However, embodiments of the disclosure are not limited thereto. In another embodiment, the display module DM may further include an additional flexible film to electrically connect the input sensing layer ISP to the printed circuit board PCB.

The display device DD may further include a housing EDC to receive the display module DM. The housing EDC may be coupled to the window WM to define an outer appearance of the display device DD. The housing EDC may absorb the impact applied from the outside and prevent a foreign substance/moisture from being infiltrated into the display module DM to protect components received in the housing EDC. Meanwhile, the housing EDC may be provided in the form in which multiple receiving members are coupled.

The display device DD may further include an electronic module including various functional modules to operate the display module DM, a power supply module (for example, a battery) to supply power necessary for overall operations of the display device DD, and a bracket coupled with the display module DM and/or the housing EDC to partition an inner space of the display device DD.

FIG. 3 is a schematic block diagram of a display device according to an embodiment of the disclosure.

Referring to FIG. 3, a display device DD may be a device activated in response to an electrical signal to display an image. The display device DD may be applied to an electronic device, such as a smart watch, a tablet PC, a laptop, a computer, or a smart television.

The display device DD may include a display panel DP and a panel driver PDD to drive the display panel DP. The panel driver PDD may include a driving controller 100, a data driver 200, a scan driver 300, a light emitting driver 350, and a voltage generator 400.

The driving controller 100 may receive an image signal RGB and a control signal CTRL. The driving controller 100 may generate image data DATA by transforming a data format of the image signal RGB to be matched to the disclosure for an interface with the data driver 200. The driving controller 100 may output a scan control signal SCS, a data control signal DCS, and a light emitting driving control signal ECS.

The data driver 200 may receive the data control signal DCS and the image data DATA from the driving controller 100. The data driver 200 may transform the image data DATA into data signals and then may output the data signals to multiple data lines DL1 to DLm to be described later. The data signals may be analog data voltages corresponding to a grayscale value of the image data DATA.

The voltage generator 400 may generate voltages necessary for an operation of the display panel DP. The voltage generator 400 may generate a first driving voltage ELVDD, a second driving voltage ELVSS, a first initializing voltage Vint, and a second initializing voltage Vaint. A level of the first initializing voltage Vint may be different from a level of the second initializing voltage Vaint. The voltage generator 400 may generate voltages necessary for an operation of the display panel DP. The voltage generator 400 may further generate a bias voltage Vbias supplied to the display panel DP.

The scan driver 300 may receive the scan control signal SCS from the driving controller 100. The scan control signal SCS may include a starting signal and multiple clock signals for starting an operation of the scan driver 300. The scan driver 300 may generate multiple scan signals and sequentially output multiple scan signals to scan lines to be described later. The light emitting driver 350 may output light emitting control signals to the light emitting control lines EML1 to EMLn to be described below, in response to the light emitting driving control signal ECS from the driving controller 100. The scan driver 300 and the light emitting driver 350 may be integrated into one circuit.

The scan driver 300 may output initializing scan signals to the initializing scan lines GIL1 to GILn of the display panel DP and may output compensating scan signals to the compensating scan lines GCL1 to GCLn of the display panel DP. The scan driver 300 may output write scan signals to the write scan lines GWL1 to GWLn of the display panel DP and may output black scan signals to the black scan lines GBL1 to GBLn of the display panel DP.

The display panel DP may include the initializing scan lines GIL1 to GILn, the compensating scan lines GCL1 to GCLn, the write scan lines GWL1 to GWLn, the black scan lines GBL1 to GBLn, light emitting control lines EML1 to EMLn, data lines DL1 to DLm, and pixels PX. The display panel DP may include the display region DA and the non-display region NDA. The initializing scan lines GIL1 to GILn, the compensating scan lines GCL1 to GCLn, the write scan lines GWL1 to GWLn, the black scan lines GBL1 to GBLn, the light emitting control lines EML1 to EMLn, the data lines DL1 to DLm, and the pixels PX may be disposed in the display region DA. The initializing scan lines GIL1 to GILn, the compensating scan lines GCL1 to GCLn, the write scan lines GWL1 to GWLn, the black scan lines GBL1 to GBLn, and the light emitting control lines EML1 to EMLn may extend in the first direction DR1, and may be arranged to be spaced apart from each other in the second direction DR2. The data lines DL1 to DLm may extend in the second direction DR2 and are arranged while being spaced apart from each other in the first direction DR1.

The scan driver 300 and the light emitting driver 350 may be disposed in the non-display region NDA of the display panel DP. The scan driver 300 may be disposed adjacent to a first side of the display region DA, and the light emitting driver 350 may be disposed at a second side, which is opposite to the first side, of the display region DA. According to an embodiment illustrated in FIG. 3, the scan driver 300 and the light emitting driver 350 may be disposed at opposite sides of the display region DA, but embodiments of the disclosure are not limited thereto. For example, the scan driver 300 and the light emitting driver 350 may be disposed adjacent to each other at one of the first side and the second side of the display panel DP.

Multiple pixels PX may be electrically connected to the initializing scan lines GIL1 to GILn, the compensating scan lines GCL1 to GCLn, the write scan lines GWL1 to GWLn, the black scan lines GBL1 to GBLn, the light emitting control lines EML1 to EMLn, and the data lines DL1 to DLm. Each of multiple pixels PX may be electrically connected to four scan lines and one light emitting control line. For example, as illustrated in FIG. 3, a first row of pixels may be electrically connected to the first initializing scan line GIL1, the first compensating scan line GCL1, the first write scan line GWL1, the first black scan line GBL1, and the first light emitting control line EML1. A second row of pixels may be electrically connected to the second initializing scan line GIL2, the second compensating scan line GCL2, the second write scan line GWL2, the second black scan line GBL2, and the second light emitting control line EML2. However, the number of scan lines and light emitting control lines, which are connected to each pixel PX, is not limited thereto, but the number of scan lines and the number of light emitting control lines may be variable.

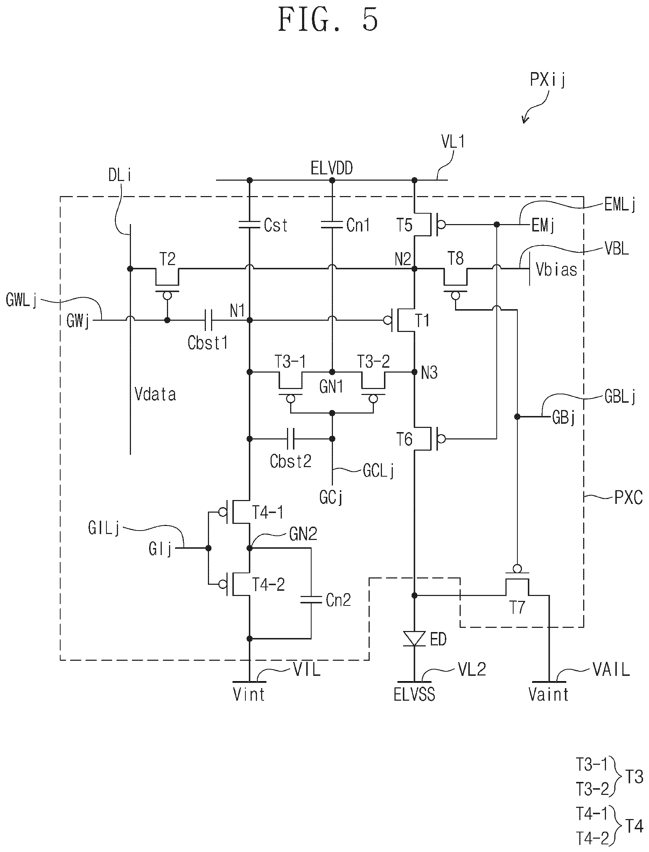

Each of multiple pixels PX may include a light emitting element ED (see FIG. 5) and a pixel circuit unit PXC (see FIG. 5) controlling the light emitting element ED to emit light. The pixel circuit unit PXC may include at least one transistor and at least one capacitor. The scan driver 300 and the light emitting driver 350 may be directly formed in the non-display region NDA of the display panel DP, through a process the same as a process of forming the transistors of the pixel circuit unit PXC.

Each of multiple pixels PX may receive a first driving voltage ELVDD, a second driving voltage ELVSS, a first initializing voltage Vint, and a second initializing voltage Vaint from the voltage generator 400. In another embodiment, each of multiple pixels PX may further receive a bias voltage Vbias from the voltage generator 400.

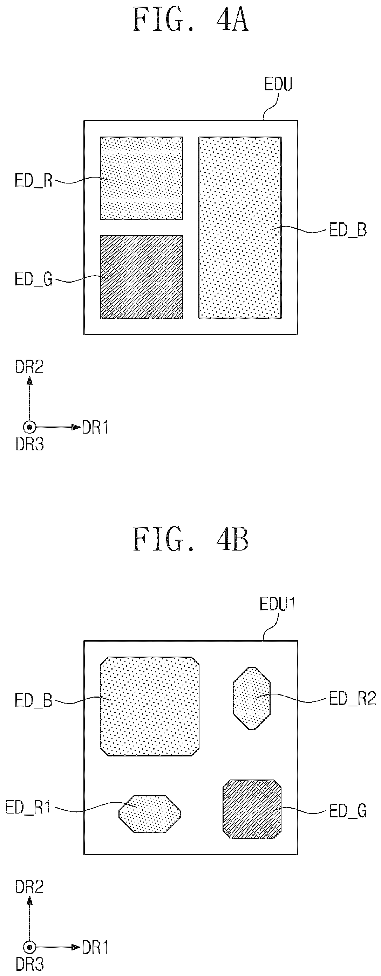

FIGS. 4A to 4D are schematic plan views illustrating the arrangement of light emitting element units according to embodiments of the disclosure. FIGS. 4A to 4D illustrate one light emitting element unit EDU.

Referring to FIG. 4A, the light emitting element unit EDU may include three light emitting elements (hereinafter, referred to as first to third light emitting elements ED_R, ED_G, and ED_B). The first light emitting element ED_R may generate a first light (for example, a red light), the second light emitting element ED_G may generate a second light (for example, a green light), and a third light emitting element ED_B may generate a third light (for example, a blue light). The first light emitting element ED_R may be included in a first pixel (or a red pixel) among multiple pixels PX, the second light emitting element ED_G may be included in a second pixel (or a green pixel) among multiple pixels PX, and the third light emitting element ED_B may be included in a third pixel (or a blue pixel) among multiple pixels PX.

The first light emitting element ED_R and the second light emitting element ED_G in the light emitting element unit EDU may be arranged in a direction parallel to the second direction DR2, and the third light emitting element ED_B may be disposed to be disposed adjacent to each of the first light emitting element ED_R and the second light emitting element ED_G in the first direction DR1. The third light emitting element ED_B may be disposed to overlap the first light emitting element ED_R and the second light emitting element ED_G, when viewed in the first direction DR1. In another embodiment, the third light emitting element ED_B may include a first sub-light emitting element disposed adjacent to the first light emitting element ED_R, and a second sub-light emitting element disposed adjacent to the second light emitting element ED_G. The first and second sub-light emitting element may share an anode electrode.

The first and the second light emitting elements ED_R and ED_G may have same rectangular shapes and areas. However, the third light emitting elements ED_B may have rectangular shape, but have larger area than the first and the second light emitting elements ED_R and ED_G. Meanwhile, the shapes or the arrangement of the first to third light emitting elements ED_R, ED_G, and ED _B, or the number of the light emitting elements constituting the light emitting element unit EDU may be variously selected, but embodiments of the disclosure are not limited thereto.

The sequence of arranging the first to third light emitting elements ED_R, ED_G, and ED_B may be provided in various combinations based on the required characteristics of the display quality. The area of each of the first to third light emitting elements ED_R, ED_G, and ED_B is not limited to the area illustrated in FIG. 4A.

As illustrated in FIG. 4B, a light emitting element unit EDU1 may include four light emitting elements (hereinafter, referred to as "first and second sub-light emitting elements ED_R1 and ED_R2, and second and third light emitting elements ED_G and ED_B"). The first and second sub-light emitting elements ED_R1 and ED_R2 may generate the first light (for example, the red light). The first and second sub-light emitting elements ED_R1 and ED_R2 may be included in the first pixel (or the red pixel), the second light emitting element ED_G may be included in the second pixel (or the green pixel), and the third light emitting element ED_B may be included in the third pixel (or the blue pixel). The first and second sub-light emitting elements ED_R1 and ED_R2 may share an anode electrode.

The first sub-light emitting element ED_R1 and the second light emitting element ED_G may be disposed adjacent to each other in the first direction DR1, and the second sub-light emitting element ED_R2 and the second light emitting element ED_G may be disposed adjacent to each other in the second direction DR2. The first sub-light emitting element ED_R1 and the third light emitting element ED_B may be disposed adjacent to each other in the second direction DR2, and the second sub-light emitting element ED_R2 and the third light emitting element ED_B may be disposed adjacent to each other in the first direction DR1.

The third light emitting element ED_B may have the same shape as the second light emitting element ED_G, and may have a larger area (or larger size) than the second light emitting element ED_G. The first and second sub-light emitting elements ED_R1 and ED_R2 may have the same size and the same shape. The first and second sub-light emitting elements ED_R1 and ED_R2 may have the shapes different from the shape of the second and third light emitting elements ED_G and ED_B, but embodiments of the disclosure are not limited thereto.

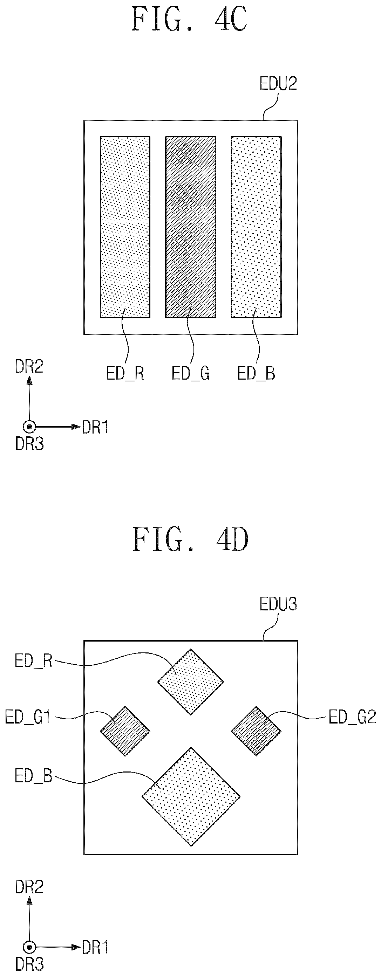

As illustrated in FIG. 4C, a light emitting element unit EDU2 may have a stripe pixel structure in which the first to third light emitting elements ED_R, ED_G, and ED_B are sequentially arranged in the first direction DR1. The first to third light emitting elements ED_R, ED_G, and ED_B may have the same rectangular shape and areas as each other, but embodiments of the disclosure are not limited thereto.

In another embodiment, as illustrated in FIG. 4D, a light emitting element unit EDU3 may include first to fourth light emitting elements ED_R, ED_G1, ED_B, and ED_G2 arranged in a pentile shape. In detail, the second and fourth light emitting elements ED_G1 and ED_G2 may generate green light. The first light emitting element ED_R may be included in the first pixel (or the red pixel), the second light emitting element ED_G1 may be included in the second pixel (or the first green pixel), the third light emitting element ED_B may be included in the third pixel (or the blue pixel), and the fourth light emitting element ED_G2 may be included in the fourth pixel (or a second green pixel).

The first to fourth light emitting elements ED_R, ED_G1, ED_B, and ED_G2 may have a diamond shape. The second and fourth light emitting elements ED_G1 and ED_G2 may have smaller areas than the first and third light emitting elements ED_R and ED _B, but embodiments of the disclosure are not limited thereto.

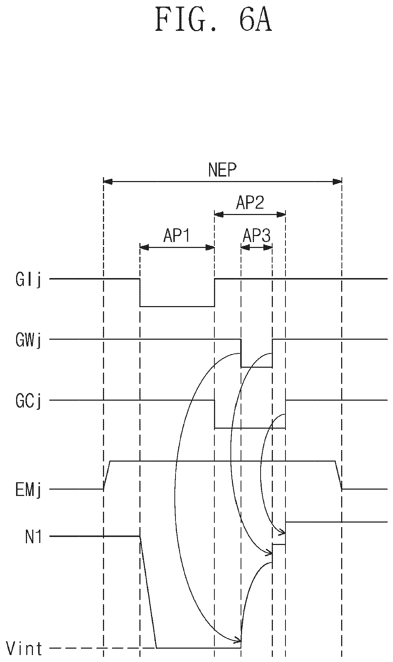

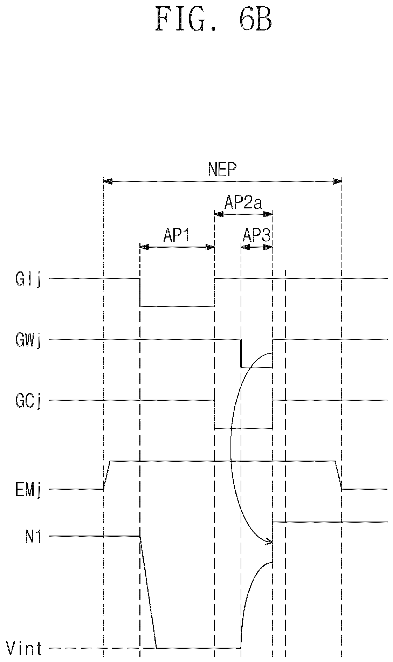

FIG. 5 is a schematic diagram of an equivalent circuit according to an embodiment of the disclosure, and FIGS. 6A and 6B are timing diagrams for describing an operation of a pixel according to an embodiment of the disclosure. The pixels PX illustrated in FIG. 3 may have the same configuration. Accordingly, the following description will be made with reference to FIG. 5 while focusing on a configuration of one pixel PXij of the pixels PX, and the description about the remaining pixels will be omitted below.

Referring to FIG. 5, the pixel PXij may be connected to a j-th initializing scan line GILj of the initializing scan lines GIL1 to GILn illustrated in FIG. 3, a j-th compensating scan line GCLj of the compensating scan lines GCL1 to GCLn illustrated in FIG. 3, a j-th write scan line GWLj of the write scan lines GWL1 to GWLn illustrated in FIG. 3, and a j-th black scan line GBLj of the black scan lines GBL1 to GBLn illustrated in FIG. 3. The pixel PXij may be connected to an i-th data line DLi of the data lines DL1 to DLm illustrated in FIG. 3, and a j-th light emitting control line EMLj of the light emitting control lines EML1 to EMLn illustrated in FIG. 3.

Referring to FIG. 5, the pixel PXij according to an embodiment may include the pixel circuit unit PXC and the light emitting element ED. The pixel circuit unit PXC may include eight transistors and five capacitors. Hereinafter, the eight transistors are referred to as first to eighth transistors T1, T2, T3, T4, T5, T6, T7, and T8, respectively, and the five capacitors are referred to as storage capacitors Cst, first and second boost capacitors Cbst1 and Cbst2, and first and second node capacitors Cn1 and Cn2.

According to an embodiment, each of the first to eighth transistors T1 to T8 may be P-type transistors having a low-temperature polycrystalline silicon (LTPS) semiconductor layer. In another embodiment, each of the first to eighth transistors T1 to T8 may be a N-type transistor. At least one of the first to eighth transistors T1 to T8 may be an N-type transistor, and the remaining transistors may be P-type transistors. In another embodiment, at least one of the first to eighth transistors T1 to T8 may be a transistor having an oxide semiconductor layer. For example, some of the first to eighth transistors T1 to T8 may be oxide semiconductor transistors, and remaining transistors may be LTPS transistors.

According to the disclosure, the circuit configuration of the pixel PXij is not limited to the circuit configuration illustrated in FIG. 5. The pixel PXij illustrated in FIG. 5 may be provided only for the illustrative purpose, and the circuit configuration of the pixel PXij may be modified and implemented. According to an embodiment of the disclosure, one (for example, the eighth transistor T8) of the first to eighth transistors T1 to T8 may be omitted from the pixel circuit unit PXC. In another embodiment, the pixel circuit unit PXC may further include at least one additional transistor in addition to eight transistors T1 to T8.

The j-th write scan line GWLj (or referred to as a first scan line) applies a j-th write scan signal GWj (or referred to as a first scan signal) to the pixel PXij, and the j-th compensating scan line GCLj (or referred to as a second scan line) applies a j-th compensating scan signal GCj (or referred to as a second scan signal) to the pixel PXij. The j-th initializing scan line GILj (or referred to as a third scan line) applies a j-th initializing scan signal GIj (or referred to as a third scan signal) to the pixel PXij, and the j-th black scan line GBLj (or referred to as a fourth scan line) applies a j-th black scan signal GBj (or referred to as a fourth scan signal) to the pixel PXij. The j-th light emitting control line EMLj applies a j-the light emitting control signal EMj to the pixel PXij, and the i-th data line DLi transmits an i-th data voltage Vdata to the pixel PXij. The i-th data voltage Vdata may have a voltage level corresponding to the image data DATA input to the display device DD (see FIG. 3).

The pixel PXij may be connected to a first driving voltage line VL1, a second driving voltage line VL2, a first initializing voltage line VIL, a second initializing voltage line VAIL, and a bias voltage line VBL.

The first driving voltage line VL1 transmits the first driving voltage ELVDD, which is supplied from the voltage generator 400 illustrated in FIG. 3, to the pixel PXij, and the second driving voltage line VL2 transmits the second driving voltage ELVSS, which is supplied from the voltage generator 400, to the pixel PXij. The first initializing voltage line VIL and the second initializing voltage line VAIL receive the first and second initializing voltages Vint and Vaint from the voltage generator 400, respectively, and transmit the received voltages Vint and Vaint to the pixel PXij, respectively. The bias voltage line VBL may receive the bias voltage Vbias from the voltage generator 400 and may transmit the bias voltage Vbias to the pixel PXij.

Each of the first to eighth transistors T1 to T8 may include an input electrode (or a source electrode), an output electrode (or a drain electrode), and a control electrode (or a gate electrode). In the disclosure, for the convenience of explanation, an input electrode, an output electrode, and a control electrode may be referred to as a first electrode, a second electrode, and a third electrode, respectively.

The first transistor T1 (or referred to as a driving transistor) may be provided between the first driving voltage line VL1 and the light emitting element ED. In detail, the first transistor T1 may include a gate electrode (or a third electrode) connected to a first node N1, a first electrode electrically connected to the first driving voltage line VL1, and a second electrode electrically connected to a third node N3. The first transistor T1 may operate based on the potential at the first node N1. The first transistor T1 may receive the first driving voltage ELVDD through the first driving voltage line VL1. The first electrode of the first transistor T1 may be electrically connected to the first driving voltage line VL1 through the fifth transistor T5, the second electrode of the first transistor T1 may be electrically connected to the anode of the light emitting element ED through the sixth transistor T6.

The second transistor T2 (or referred to as a switching transistor) may be provided between the i-th data line DLi and the second node N2. In detail, the second transistor T2 may include a gate electrode to receive the j-th write scan signal GWj through the j-th write scan line GWLj, a first electrode connected to the i-th data line DLi, and a second electrode connected to the second node N2. The second transistor T2 may be turned on, in response to the j-th write scan signal GWj applied through the j-th write scan line GWLj, during a data write period AP3 (see FIG. 6A). The i-th data line DLi and the second node N2 may be electrically connected to each other by the turned-on second transistor T2, and the i-th data voltage Vdata supplied to the i-th data line DLi may be supplied to the second node N2 through the turned-on second transistor T2.

The storage capacitor Cst may be connected between the first node N1 and the first driving voltage line VL1. The storage capacitor Cst may include a first capacitor electrode electrically connected to the first node N1 and a second capacitor electrode electrically connected to the first driving voltage line VL1.

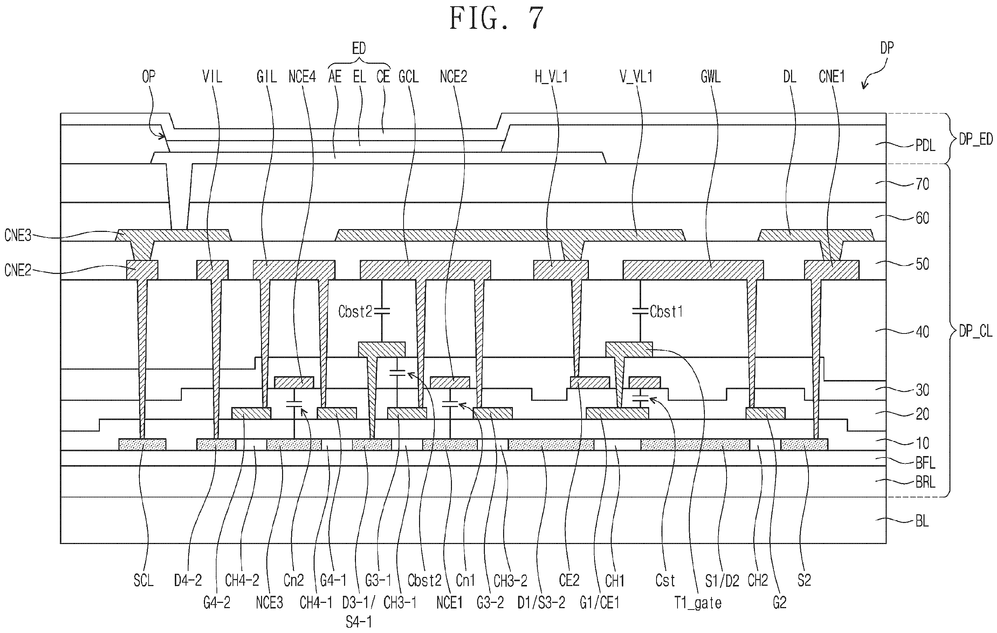

The first boost capacitor Cbst1 may be connected between the first node N1 and the j-th write scan line GWLj. The first boost capacitor Cbst1 may be provided in an overlapping region between an additional gate electrode T1_gate (see FIG. 7) electrically connected to the first node N1 and the j-th write scan line GWLj.

The third transistor T3 (or referred to as a compensating transistor) may be connected between the second electrode of the first transistor T1 and the third electrode of the first transistor T1. The third transistor T3 may include a first sub-transistor T3-1 and a second sub-transistor T3-2 electrically connected in series to each other between the first and third nodes N1 and N3. The first sub-transistor T3-1 may be connected between the first node N1 and a first coupling node GN1, and the second sub-transistor T3-2 may be connected between the first coupling node GN1 and the third node N3.

The second sub-transistor T3-2 may include a first electrode connected to the third node N3, a second electrode connected to the first coupling node GN1, and a third electrode to receive a j-th compensating scan signal GCj applied through the j-th compensating scan line GCLj. The first sub-transistor T3-1 may include a first electrode connected to the first coupling node GN1, a second electrode connected to the first node N1, and a third electrode to receive the j-th compensating scan signal GCj applied through the j-th compensating scan line GCLj. The first transistor T1 may be diode-connected by the first sub-transistor T3-1 and the second sub-transistor T3-2, which are turned on during a compensating period AP2.

The first node capacitor Cn1 may be connected between the first coupling node GN1 and the first driving voltage line VL1. The first node capacitor Cn1 may include a first node capacitor electrode, which is electrically connected to the first coupling node GN1, and a second node capacitor electrode which is electrically connected to the first driving voltage line VL1.

Although FIG. 5 illustrates the structure that the third transistor T3 includes two sub-transistors, embodiments of the disclosure are not limited thereto. For example, the third transistor T3 may include one transistor. In another embodiment, the third transistor T3 may include at least three sub-transistors.

The second boost capacitor Cbst2 may be connected between the first node N1 and the j-th compensating scan line GCLj. The second boost capacitor Cbst2 may be provided in an overlapping region between the additional gate electrode T1_gate (see FIG. 7) electrically connected to the first node N1 and the j-th compensating scan line GCLj.

The fourth transistor T4 (or referred to as the first initializing transistor) may be electrically connected between the first node N1 and the first initializing voltage line VIL. The fourth transistor T4 may include a third sub-transistor T4-1 and a fourth sub-transistor T4-2 in-series connected to each other between the first node N1 and the first initializing voltage line VIL. The third sub-transistor T4-1 may be connected between the first node N1 and a second coupling node GN2, and the fourth sub-transistor T4-2 may be connected between the second coupling node GN2 and the first initializing voltage line VIL.

The third sub-transistor T4-1 may include a first electrode electrically connected to the first node N1, a second electrode electrically connected to the second coupling node GN2, and a third electrode to receive a j-th initializing scan signal GIj applied through the j-th initializing scan line GILj. The fourth sub-transistor T4-2 may include a first electrode electrically connected to the second coupling node GN2, a second electrode electrically connected to the first initializing voltage line VIL, and a third electrode to receive the j-th initializing scan signal GIj applied through the j-th initializing scan line GILj.

The first initializing voltage Vint may be applied to the first initializing voltage line VIL. The third and fourth sub-transistors T4-1 and T4-2 are turned on, in response to the j-th initializing scan signal GIj applied through the j-th initializing scan line GILj, during an initializing period AP1 (see FIG. 6A). The first node N1 may be initialized to the first initializing voltage Vint by the third sub-transistor T4-1 and the fourth sub-transistor T4-2, which are turned on during the initializing period AP1.

The second node capacitor Cn2 may be connected between the second coupling node GN2 and the first initializing voltage line VIL. The second node capacitor Cn2 may include a third node capacitor electrode electrically connected to the second coupling node GN1 and a fourth node capacitor electrode electrically connected to the first initializing voltage line VIL.

Although FIG. 5 illustrates the structure that the fourth transistor T4 may include two sub-transistors, embodiments of the disclosure are not limited thereto. For example, the fourth transistor T4 may include one transistor. In another embodiment, the fourth transistor T4 may include at least three sub-transistors.

According to an embodiment of the disclosure, each of the third and fourth transistors T3 and T4 may have the structure (for example, referred to as a dual-transistor structure) of including multiple sub-transistors connected to each other in series. In case that the third and fourth transistors T3 and T4 have the dual transistor structure and are turned off, the third and fourth transistors T3 and T4 may reduce a leakage current. In another embodiment, at least one of the first to eighth transistors T1 to T8 may have a dual gate structure including two gate electrodes.

As described above, as the first and second node capacitors Cn1 and Cn2 are formed at the first and second coupling nodes GN1 and GN2 of the third and fourth transistors T3 and T4 having the dual transistor structure, the leakage current of each of the third and fourth transistors T3 and T4 may be more prevented.

Although FIG. 5 illustrates the structure that the pixel circuit unit PXC includes two node capacitors Cn1 and Cn2, embodiments of the disclosure are not limited thereto. For example, any one of the first and second node capacitors Cn1 and Cn2 may be omitted from the pixel circuit unit PXC.

The fifth transistor T5 may be electrically connected between the second node N2 and the first driving voltage line VL1. The fifth transistor T5 may include a gate electrode to receive the j-th light emitting control signal EMj through the j-th light emitting control line EMLj, a first electrode electrically connected to the first driving voltage line VL1, and a second electrode electrically connected to the second node N2.

The sixth transistor T6 may be electrically connected between the third node N3 and the light emitting element ED. The sixth transistor T6 may include a gate electrode to receive the j-th light emitting control signal EMj through the j-th light emitting control line EMLj, a first electrode connected to the third node N3, and a second electrode electrically connected to the anode of the light emitting element ED.

According to an embodiment of the disclosure, although the gate electrodes of the fifth and sixth transistors T5 and T6 are connected to the j-th light emitting control line EMLj in common, embodiments of the disclosure are not limited thereto. In another embodiment, the gate electrode of the fifth transistor T5 and the gate electrode of the sixth transistor T6 may be connected to light emitting control lines different from each other to receive light emitting control signals different from each other.

The fifth and sixth transistors T5 and T6 may be turned off in response to the j-th light emitting control signal EMj in a high state during a non-light emitting period NEP (see

FIG. 6A), and may be turned on in response to the j-th light emitting control signal EMj in a low state during a light emitting period.

The light emitting element ED may be electrically connected between the sixth transistor T6 and the second driving voltage line VL2. The anode of the light emitting element ED may be connected to the second electrode of the sixth transistor T6, and the cathode of the light emitting element ED may be connected to the second driving voltage line VL2. The second driving voltage ELVSS may be applied to the second driving voltage line VL2. The second driving voltage ELVSS may have a level lower than a level of the first driving voltage ELVDD. Accordingly, the light emitting element ED may emit light based on a voltage corresponding to the difference between a signal received through the sixth transistor T6 and the second driving voltage ELVSS during the light emitting period.

The seventh transistor (or referred to as a second initializing transistor) T7 may be connected between the second initializing voltage line VAIL and the anode of the light emitting element ED. The seventh transistor T7 may include a gate electrode to receive the j-th black scan signal GBj (or referred to as an "initializing control signal") through the j-th black scan line GBLj, a first electrode connected to the anode of the light emitting element ED, and a second electrode connected to the second initializing voltage line VAIL. The second initializing voltage Vaint may be supplied to the second initializing voltage line VAIL. The second initializing voltage Vaint has a voltage level different from a voltage level of the first initializing voltage Vint. The seventh transistor T7 may be turned on, in response to the j-th black scan signal GBj applied through the j-th black scan line GBLj. The anode of the light emitting element ED may be initialized to the second initializing voltage Vaint, by the seventh transistor T7 turned on. In another embodiment, the gate electrode of the seventh transistor T7 may be electrically connected to a (j+1)-th write scan line to receive a (j+1)-th write scan signal as the j-th black scan signal GBj.

The eighth transistor (or referred to as a bias transistor) T8 may be electrically connected between the first transistor T1 and the bias voltage line VBL. For example, the eighth transistor T8 may include a gate electrode to receive the j-th black scan signal GBj (or referred to as a bias control signal) through the j-th black scan line GBLj, a first electrode electrically connected to the bias voltage line VBL, and a second electrode electrically connected to the first electrode (e.g., the second node N2) of the first transistor T1. The bias voltage Vbias may be applied to the bias voltage line VBL. The eighth transistor T8 may be turned on, in response to the j-th black scan signal GBj applied through the j-th black scan line GBLj. The bias voltage Vbias may be supplied to the second node N2 through the eighth transistor T8 turned on.

Referring to FIGS. 5 and 6A, the j-th light emitting control signal EMj may include the non-light emitting period NEP. The non-light emitting period NEP may be defined as a non-active period (e.g., a high-level period) of the j-th light emitting control signal EMj. A low-level period of the j-th light emitting control signal EMj may be defined as the light emitting period.

The j-th initializing scan signal GIj may have the initializing period AP1 (e.g., the low-level period) in the non-light emitting period NEP. The j-th initializing scan signal GIj is supplied to the fourth transistor T4 through the j-th initializing scan line GILj, and the fourth transistor T4 may be turned on during the initializing period AP1 in which the j-th initializing scan signal GIj is activated. The potential at the first node N1 may be initialized to the first initializing voltage Vint by the fourth transistor T4, which is turned on, during the initializing period AP1.

The j-th compensating scan signal GCj may have the compensating period AP2 (e.g., the low-level period) in the non-light emitting period NEP. In case that the j-th compensating scan signal GCj is applied to the third transistor T3 through the j-th compensating scan line GCLj, the third transistor T3 may be turned on during the compensating period AP2. The first transistor T1 may be diode-connected by the third transistor T3 which is turned on, and biased forward. Then, the compensating voltage "ELVDD-Vth", which is obtained by subtracting the threshold voltage Vth of the first transistor T1 from the first driving voltage ELVDD may be applied to the first node N1. In another embodiment, the potential at the first node N1 may be compensated with the compensating voltage "ELVDD-Vth" during the compensating period AP2.

The duration of the compensating period AP2 may be equal to the duration of the initializing period AP1.

The j-th write scan signal GWj may have the data write period AP3 (e.g., the low-level period) in the non-light emitting period NEP. The j-th write scan signal GWj is applied to the second transistor T2 through the j-th write scan line GWLj, and the second transistor T2 may be turned on during the data write period AP3. The i-th data voltage Vdata may be applied to the second node N2 through the second transistor T2, which is turned on, during the data write period AP3. Then, the potential at the second node N2 may be changed to the i-th data voltage Vdata.

The duration of the compensating period AP2 may be greater than or equal to the duration of the data write period AP3, that is, the compensating period AP2 and the data write period AP3 may overlap each other. Although FIG. 6A illustrates that a starting time point (for example, a falling time point) of the data write period AP3 follows a starting time point (for example, a falling time point) of the compensating period AP2, and a terminating time point (for example, a rising time point) of the data write period AP3 advances a terminating time point (for example, a rising time point) of the compensating period AP2, embodiments of the disclosure are not limited thereto. In another embodiment, as illustrated in FIG. 6B, the falling time point of the data write period AP3 follows the falling time point of a compensating period AP2a, and the rising time point of the data write period AP3 may be matched to the rising time point of the compensating period AP2a.

The third transistor T3 may be maintained turned on during the data write period AP3. Accordingly, the potential at the first node N1 may be varied based on the i-th data voltage Vdata. For example, in case that the i-th data voltage Vdata is a black data voltage for expressing a black grayscale value, the potential at the first node N1 may gradually rise from the falling time point of the data write period AP3, and the rising of the potential at the first node N1 may be stopped at the rising time point of the data write period AP3. However, in case that the duration of the data write period AP3 is shorter, the potential at the first node N1 may be terminated without rising to the black data voltage.

The first boost capacitor Cbst1 may be connected between the j-th write scan line GWLj and the first node N1. Accordingly, in case that the j-th write scan signal GWj, which is applied to the j-th write scan line GWLj, rises to be in a high level at the rising time point, the potential at the first node N1 may be primarily boosted up through the coupling phenomenon. Accordingly, the potential at the first node N1 may be boosted up (rise) by a specific level at the rising time point of the data write period AP3.

Thereafter, the second boost capacitor Cbst2 may be connected between the j-th compensating scan line GCLj and the first node N1. Accordingly, in case that the j-th compensating scan signal GCj, which is applied to the j-th compensating scan line GCLj, rises to be in a high level at the rising time point, the potential at the first node N1 may be secondarily boosted up through the coupling phenomenon. The potential at the first node N1 may be boosted up (re-rise) by a specific level at the rising time point of the compensating period AP2.

Accordingly, as compared to a pixel circuit unit PXC without the first and second boost capacitors Cbst1 and Cbst2, the potential at the first node N1 may sufficiently rise to the black data voltage. Accordingly, the pixel may accurately implement the black grayscale value.

As illustrated in FIG. 6B, in case that the rising time point of the j-th compensating scan signal GCj is matched to the rising time point of the j-th write scan signal GWj, the primarily-boosting operation and the secondary-boosting operation may simultaneously occur. In another embodiment, the potential at the first node N1 may rise to the black data voltage through one boosting operation, at the rising time points of the j-th compensating scan signal GCj and the j-th write scan signal GWj.

In case that the pixel circuit unit PXC has no the first and second boost capacitors Cbst1 and Cbst2, to rise the potential at the first node N1 to a desirable black data voltage (e.g., a target voltage) during the specific data write period AP3, the i-th data voltage Vdata higher than the target voltage should be supplied to the pixel circuit unit PXC. For example, a larger amount of power may be consumed to drive the display device DD (see FIG. 3). However, in case that the pixel circuit unit PXC has the first and second boost capacitors Cbst1 and Cbst2, the potential at the first node N1 may rise through the boosting operation. Accordingly, an i-th data voltage Vdata higher than the target voltage needs not to be supplied to express the black grayscale value, thereby reducing the power consumption of the display device DD.

FIG. 7 is a schematic cross-sectional view of a display panel according to an embodiment of the disclosure.

Referring to FIG. 7, the display panel DP may include the base layer BL, the circuit layer DP_CL, and the element layer DP_ED.

The base layer BL may include a synthetic resin layer. The synthetic resin layer may include a thermosetting resin material. In particular, the synthetic resin layer may be a polyimide-based resin layer, and the material thereof is not particularly limited. The synthetic resin layer may include at least one of an acrylic resin, a methacrylic resin, a polyisoprene resin, a vinyl resin, an epoxy resin, a urethane resin, a cellulose resin, a siloxane resin, a polyamide resin, or a perylene resin. The base layer BL may include a glass substrate, a metal substrate, or an organic/inorganic composite material substrate.

The circuit layer DP_CL may be disposed on the base layer BL. The circuit layer DP_CL may include at least one inorganic layer disposed on a top surface of the base layer BL. The inorganic layer may include at least one of an aluminum oxide, a titanium oxide, a silicon oxide, a silicon oxy nitride, a zirconium oxide, or a hafnium oxide. The inorganic layer may be formed in multiple layers. The multiple inorganic layers may constitute a barrier layer BRL and/or a buffer layer BFL. The barrier layer BRL and the buffer layer BFL may be disposed selectively.

The barrier layer BRL may be disposed on the base layer BL to prevent foreign substances from being introduced from the outside. The barrier layer BRL may include a silicon oxide layer and a silicon nitride layer. The silicon oxide layer may include multiple silicon oxide layers and the silicon nitride layer may include multiple silicon nitride layers, and the silicon oxide layers and the silicon nitride layers may be alternately stacked.

The buffer layer BFL may be disposed on the barrier layer BRL. The buffer layer BFL improves a bonding force between the base layer BL and a semiconductor pattern and/or a conductive pattern. The buffer layer BFL may include a silicon oxide layer and a silicon nitride layer. The silicon oxide layer and the silicon nitride layer may be alternately stacked. The barrier layer BRL and the buffer layer BFL may be omitted.

The circuit layer DP_CL may include a semiconductor pattern disposed on the buffer layer BFL. The semiconductor pattern may include a silicon semiconductor. The semiconductor pattern may include polysilicon. However, embodiments of the disclosure are not limited thereto. For example, the semiconductor pattern may include amorphous silicon or an oxide semiconductor.

The semiconductor pattern may have an electrical characteristic based on whether the semiconductor pattern is doped. Each semiconductor pattern may include a doping region and a non-doping region. The doping region may be doped with an N-type dopant or a P-type dopant. A P-type transistor may include a doping region doped with the P-type dopant, and an N-type transistor may include a doping region doped with the N-type dopant.

The doping region may be greater than the non-doping region in conductivity, and actually serves as an electrode or a signal line. The non-doping region actually corresponds to channel parts CH1, CH2, CH3-1, CH3-2, CH4-1, or CH4-2 of the transistor. In another embodiment, a first portion of the semiconductor pattern may be the channel part CH1, CH2, CH3-1, CH3-2, CH4-1, or CH4-2 of the transistor, a second portion of the semiconductor pattern may be a source or drain of the transistor, and a third portion of the semiconductor pattern may be a connecting signal line (or a connecting electrode) SCL.

As illustrated in FIG. 7, a first electrode S1, a channel part CH1, and a second electrode D1 of the first transistor T1 may be formed from the semiconductor pattern. The first electrode S1 and the second electrode D1 of the first transistor T1 may extend in directions opposite to each other from the channel part CH1. A first electrode S2, the channel part CH2, and a second electrode D2 of the second transistor T2 may be formed from the semiconductor pattern. The first electrode S2 and the second electrode D2 of the second transistor T2 may extend in directions opposite to each other from the channel part CH2. The second electrode D2 of the second transistor T2 and the first electrode S1 of the first transistor T1 may be formed integrally with each other.

The first electrode, the channel part CH3-1, and the second electrode D3-1 of the first sub-transistor T3-1 may be formed from a semiconductor pattern, and the first electrode S3-2, the channel part CH3-2, and the second electrode of a second sub-transistor T3-2 may be formed from the semiconductor pattern. The first electrode, and the second electrode D3-1 of the first sub-transistor T3-1 may extend in directions opposite to each other from the channel part CH3-1, and the first electrode S3-2 and the second electrode of the second sub-transistor T3-2 may extend in directions opposite to each other from the channel part CH3-2. The first electrode of the first sub-transistor T3-1 and the second electrode of the second sub-transistor T3-2 may be formed integrally with each other. The first electrode of the first sub-transistor T3-1 and the second electrode of the second sub-transistor T3-2 may be formed integrally with a first node capacitor electrode NCE1 of the first node capacitor Cn1. The first electrode S3-2 of the second sub-transistor T3-2 and the second electrode D1 of the first transistor T1 may be formed integrally with each other.

A first electrode S4-1, a channel part CH4-1, and a second electrode of a third sub-transistor T4-1 may be formed from a semiconductor pattern, and a first electrode , a channel part CH4-2, and a second electrode D4-2 of a fourth sub-transistor T4-2 may be formed from the semiconductor pattern. The first electrode S4-1, and the second electrode of the third sub-transistor T4-1 may extend in directions opposite to each other from the channel part CH4-1, and the first electrode and the second electrode D4-2 of the fourth sub-transistor T4-2 may extend in directions opposite to each other from the channel part CH4-2. The second electrode of the third sub-transistor T4-1 and the first electrode of the fourth sub-transistor T4-2 may be formed integrally with each other. The second electrode of the third sub-transistor T4-1 and the first electrode of the fourth sub-transistor T4-2 may be formed integrally with a third node capacitor electrode NCE3 of the second node capacitor Cn2.

A first insulating layer (or a gate insulating layer) 10 may be disposed on the buffer layer BFL. The first insulating layer 10 may overlap multiple pixels PX (see FIG. 3) in common, and may cover the semiconductor pattern. The first insulating layer 10 may be an inorganic layer and/or an organic layer, and may have a single-layer or multilayer structure. The first insulating layer 10 may include at least one of an aluminum oxide, a titanium oxide, a silicon oxide, a silicon oxynitride, a zirconium oxide, or a hafnium oxide. The first insulating layer 10 may be a single silicon oxide layer. In addition to the first insulating layer 10, insulating layers of the circuit layer DP_CL, which are to be described below, may be an inorganic layer and/or an organic layer, and may have a single layer structure or a multi-layer structure. The inorganic layer may include at least one of the above-described materials.

The gate electrode G1 of the first transistor T1, the gate electrode G2 of the second transistor T2, the gate electrode G3-1 of the first sub-transistor T3-1, the gate electrode G3-2 of the second sub-transistor T3-2, the gate electrode G4-1 of the third sub-transistor T4-1, and the gate electrode G4-2 of the fourth sub-transistor T4-2 may be disposed on the first insulating layer 10. The gate electrode G1 of the first transistor T1 may overlap the channel part CH1 of the first transistor T1, and the gate electrode G2 of the second transistor T2 may overlap the channel part CH2 of the second transistor T2. The gate electrode G3-1 of the first sub-transistor T3-1 may overlap the channel part CH3-1 of the first sub-transistor T3-1, and the gate electrode G3-2 of the second sub-transistor T3-2 may overlap the channel part CH3-2 of the second sub-transistor T3-2. The gate electrode G4-1 of the third sub-transistor T4-1 may overlap the channel part CH4-1 of the third sub-transistor T4-1, and the gate electrode G4-2 of the fourth sub-transistor T4-2 may overlap the channel part CH4-2 of the fourth sub-transistor T4-2.

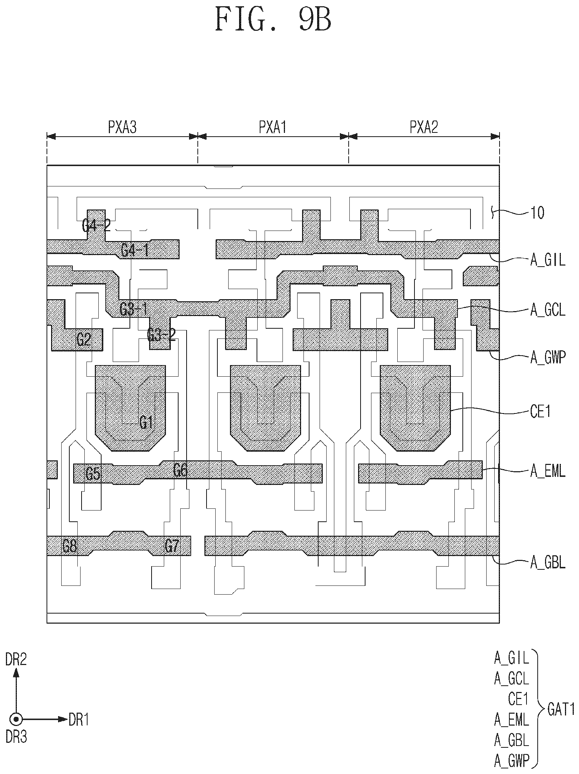

The first capacitor electrode CE1 may be further disposed on the first insulating layer 10. The first capacitor electrode CE1 may extend from the gate electrode G1 of the first transistor T1, and may be formed integrally with the gate electrode G1 of the first transistor T1. The gate electrodes G1, G2, G3-1, G3-2, G4-1, and G4-2 of the transistors T1, T2, T3-1, T3-2, T4-1, and T4-2 and the first capacitor electrode CE1 may be parts of the first gate pattern layer GAT1 illustrated in FIG. 9B.

The second insulating layer 20 may be disposed on the first insulating layer 10 to cover the gate electrodes G1, G2, G3-1, G3-2, G4-1, and G4-2 of the transistors T1, T2, T3-1, T3-2, T4-1, and T4-2 and the first capacitor electrode CE1. The second insulating layer 20 may overlap multiple pixels PX in common. The second insulating layer 20 may be an inorganic layer and/or an organic layer, and may have a single-layer or multi-layer structure. The second insulating layer 20 may be a single silicon oxide layer.

The second capacitor electrode CE2 may be disposed on the second insulating layer 20. The second capacitor electrode CE2 may face the first capacitor electrode CE1 while interposing the second insulating layer 20 between the second capacitor electrode CE2 and the first capacitor electrode CE1, to form the storage capacitor Cst. A second node capacitor electrode NCE2 and a fourth node capacitor electrode NCE4 may be further disposed on the second insulating layer 20. The second node capacitor electrode NCE2 may face the first node capacitor electrode NCE1 while interposing the first insulating layer 10 and the second insulating layer 20 between the second node capacitor electrode NCE2 and the first node capacitor electrode NCE1, to form the first node capacitor Cn1. The fourth node capacitor electrode NCE4 may face the third node capacitor electrode NCE3 while interposing the first insulating layer 10 and the second insulating layer 20 between the fourth node capacitor electrode NCE4 and the third node capacitor electrode NCE3, to form the second node capacitor Cn2.

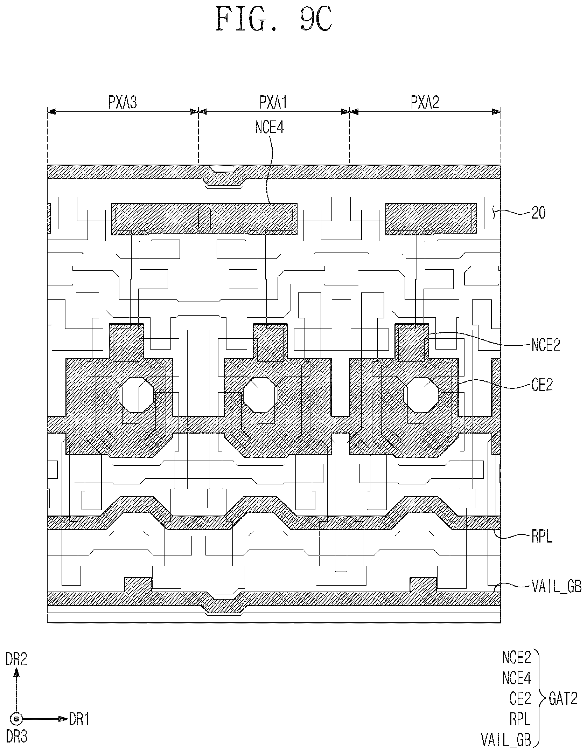

The second capacitor electrode CE2, and the second and fourth node capacitor electrodes NCE2 and NCE4 may be parts of the second gate pattern layer GAT2 illustrated in FIG. 9C.

The third insulating layer 30 may be disposed on the second insulating layer 20 to cover the second capacitor electrode CE2, the second and fourth node capacitor electrodes NCE2 and NCE4. The third insulating layer 30 may be a single silicon oxide layer.

The additional gate electrode T1_gate may be disposed on the third insulating layer 30. The additional gate electrode T1_gate may be electrically connected with the gate electrode G1 of the first transistor T1 through a contact hole which is formed through the second and third insulating layers 20 and 30. The additional gate electrode T1_gate may be electrically connected with the second electrode D3-1 of the first sub-transistor T3-1 through a contact hole which is formed through the first to third insulating layers 10, 20, and 30.

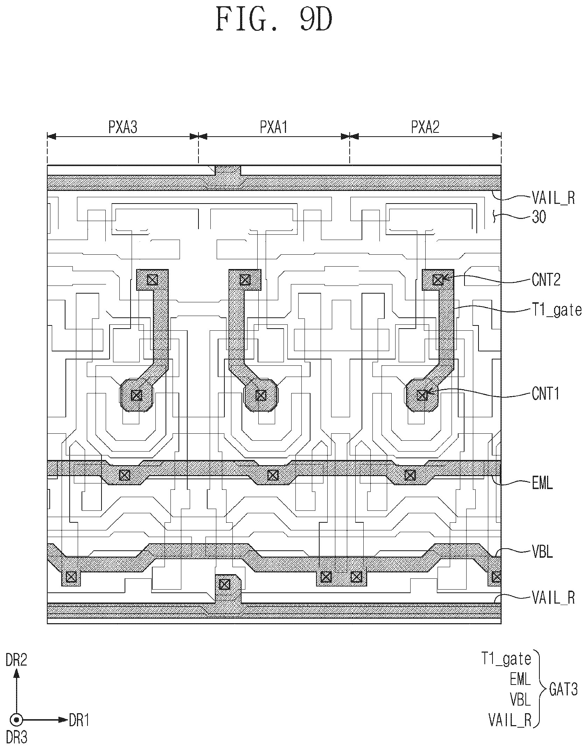

The additional gate electrode T1_gate may face the gate electrode G3-1 of the first sub-transistor T3-1 while interposing the second and third insulating layers 20 and 30 between the additional gate electrode T1_gate and the gate electrode G3-1 to form the second boost capacitor Cbst2. The additional gate electrode T1_gate may be a portion of the third gate pattern layer GAT3 illustrated in FIG. 9D. The additional gate electrode T1_gate may be disposed on a layer different from a layer for the gate electrode G1 of the first transistor T1 and the first and second capacitor electrodes CE1 and CE2. The additional gate electrode T1_gate may be in a non-overlapping state with the second and fourth node capacitor electrodes NCE2 and NCE4 in a plan view.

The write scan line GWL, the compensating scan line GCL, the initializing scan line GIL, the first initializing voltage line VIL, and the horizontal voltage line H_VL1 may be disposed on the fourth insulating layer 40. The write scan line GWL may correspond to the j-th write scan lineGWLj (e.g., the first scan line) illustrated in FIG. 5. The write scan line GWL may be electrically connected to the gate electrode G2 of the second transistor T2 through the contact hole formed through the second to fourth insulating layers 20, 30, and 40 and the write scan line GWL may face the additional gate electrode T1_gate while interposing the fourth insulating layer 40 between the write scan line GWL and the additional gate electrode T1_gate to form the first boost capacitor Cbst1. The compensating scan line GCL may correspond to the j-th compensating scan line GCLj (e.g., the second scan line) illustrated in FIG. 5. The compensating scan line GCL may be electrically connected to the gate electrode G3-1 and G3-2 of the first and second sub-transistors T3-1 and T3-2 through the contact holes formed through the second to fourth insulating layers 20, 30, and 40, and the compensating scan line GCL may face the additional gate electrode T1_gate while interposing the fourth insulating layer 40 between the compensating scan line GCL and the additional gate electrode T1_gate to form the second boost capacitor Cbst2. The initializing scan line GIL may correspond to the j-th initializing scan line GILj (e.g., the third scan line) illustrated in FIG. 5. The initializing scan line GIL may be electrically connected to the gate electrode G4-2 of the fourth sub-transistor T4-2 through the contact hole formed through the second to fourth insulating layers 20, 30, and 40.

The additional gate electrode T1_gate may be disposed on a layer different from layers for the write scan line GWL, the compensating scan line GCL, and the initializing scan line GIL.

The first initializing voltage line VIL may be electrically connected to the second electrode D4-2 of the fourth sub-transistor T4-2 through a contact hole formed through the first to fourth insulating layers 10, 20, 30, and 40, and the horizontal voltage line H_VL1 may be electrically connected to the second capacitor electrode CE2 through the contact hole formed through the third and fourth insulating layers 30 and 40.

The first and second connecting electrodes CNE1 and CNE2 may be further disposed on the fourth insulating layer 40. The first connecting electrode CNE1 may electrically connect the first electrode S2 of the second transistor T2 to the data line DL, and the second connecting electrode CNE2 may electrically connect a connecting signal line SCL to the anode AE of the light emitting element ED.

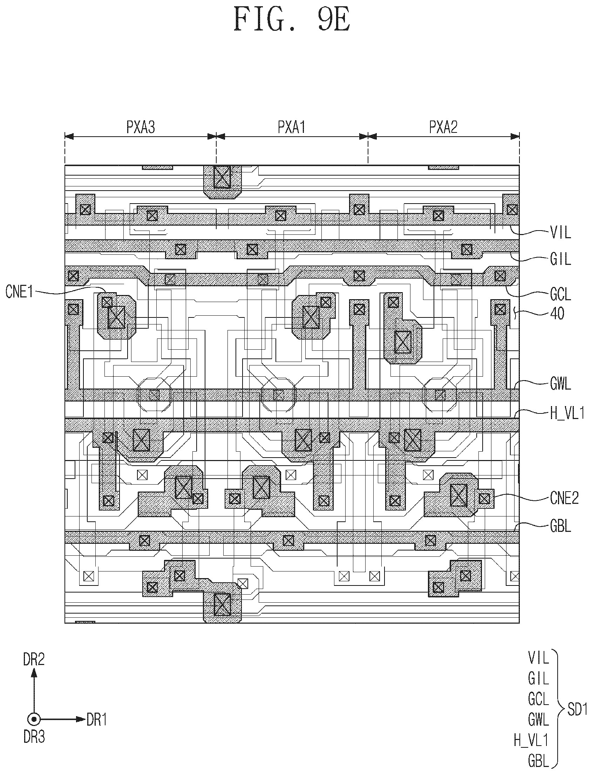

The write scan line GWL, the compensating scan line GCL, the initializing scan line GIL, the first initializing voltage line VIL, the horizontal voltage line H_VL1, and the first and second connecting electrodes CNE1 and CNE2 may be portions of the first data pattern layer SD1 illustrated in FIG. 9E.

The fifth insulating layer 50 may be disposed to cover the write scan line GWL, the compensating scan line GCL, the initializing scan line GIL, the first initializing voltage line VIL, the horizontal voltage line H_VL1, and the first and second connecting electrodes CNE1 and CNE2. The vertical voltage line V_VL1, the data line DL, and the third connecting electrode CNE3 may be disposed on the fifth insulating layer 50.

The vertical voltage line V_VL1 may be electrically connected to the horizontal voltage line H_VL1 through the contact hole formed through the fifth insulating layer 50, and the data line DL may be electrically connected to the first connecting electrode CNE1 through the contact hole formed through the fifth insulating layer 50. The third connecting electrode CNE3 may be electrically connected to the second connecting electrode CNE2 through a contact hole formed through the fifth insulating layer 50.

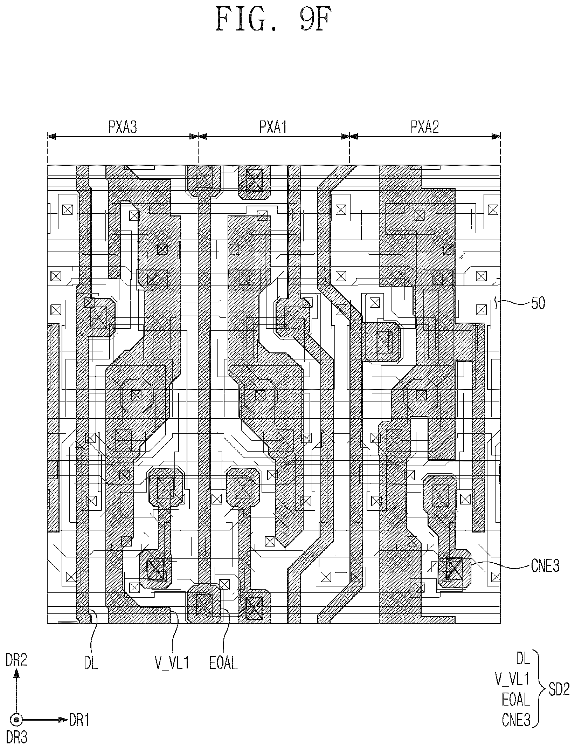

The third connecting electrode CNE3 may be electrically connected to the anode AE of the light emitting element ED. The vertical voltage line V_VL1, the data line DL, and the third connecting electrode CNE3 may be portions of the second data pattern layer SD2 illustrated in FIG. 9F.

A sixth insulating layer 60 may be disposed on the fifth insulating layer 50 to cover the vertical voltage line V_VL1, the data line DL, and the third connecting electrode CNE3, and a seventh insulating layer 70 may be disposed on the sixth insulating layer 60. The sixth and seventh insulating layers 60 and 70 may include a silicon oxide layer or a silicon nitride layer. In another embodiment, one of the sixth and seventh insulating layers 60 and 70 may be omitted.

The element layer DP_ED may be disposed on the circuit layer DP_CL. The element layer DP_ED may include the light emitting element ED and the pixel defining layer PDL. The light emitting element ED may include the anode AE, the light emitting layer EL, and the cathode CE.

The pixel defining layer PDL may include an opening OP that is defined to correspond to the light emitting element ED. The opening OP may expose at least a portion of the anode AE of the light emitting element ED. The opening OP of the pixel defining layer PDL may define a light emitting region. For example, multiple pixels PX (see FIG. 3) may be arranged in a specific rule on a plane of the display panel DP. A region, in which multiple pixels PX are disposed, may be defined as a pixel region, and one pixel region may include a light emitting region and a non-light emitting region disposed adjacent to the light emitting region. The non-light emitting region may surround the light emitting region.

The light emitting layer EL may be disposed to correspond to the opening OP defined in the pixel defining layer PDL. Although the patterned light emitting layer EL is illustrated, embodiments of the disclosure are not limited thereto. A common light emitting layer may be disposed in common in multiple pixels PX. For example, the common light emitting layer may generate a white light or a blue light.

The cathode CE may be disposed on the light emitting layer EL. The cathode CE may be disposed in common in multiple pixels PX.

The display panel DP may further include an encapsulating layer to encapsulate the element layer DP_ED. The encapsulating layer may include at least one organic film and at least one inorganic film. The inorganic film may include an inorganic material to protect the element layer DP_ED from moisture/oxygen. The inorganic film may include a silicon nitride layer, a silicon oxy nitride layer, a silicon oxide layer, a titanium oxide layer, or an aluminum oxide layer, but embodiments of the disclosure are not limited particularly thereto. The organic film may include an organic material, and may protect the element layer DP_ED from foreign substances such as dust particles.

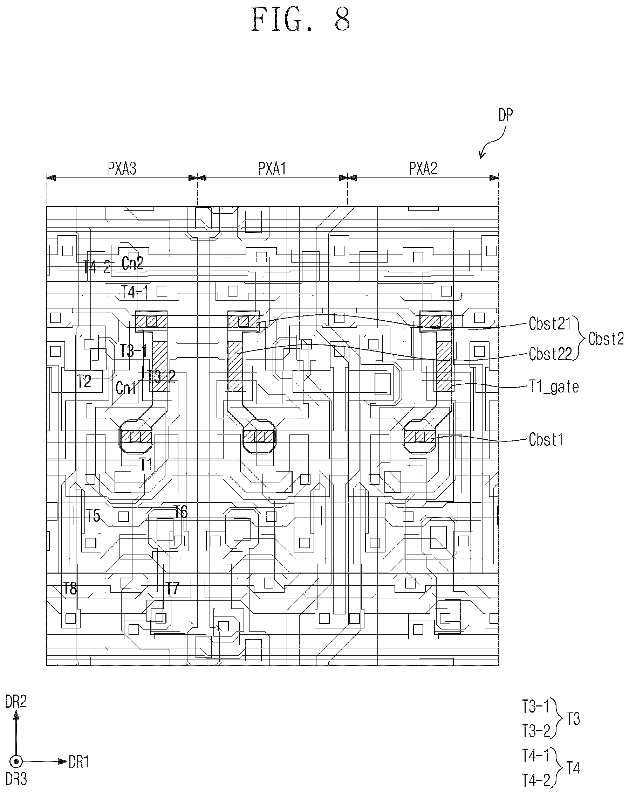

FIG. 8 is a schematic plan view illustrating a portion of a display panel according to an embodiment of the disclosure.

Referring to FIGS. 7 and 8, multiple pixel regions may be defined on the base layer BL. Multiple pixel regions may include a first pixel region PXA1 to dispose a first pixel (for example, a red pixel), a second pixel region PXA2 to dispose a second pixel (for example, a green pixel), and a third pixel region PXA3 to dispose a third pixel (for example, a blue pixel). Multiple pixel regions may be arranged in order of the third pixel region PXA3, the first pixel region PXA1, and the second pixel region PXA2 in the first direction DR1.

A first pixel circuit unit may be disposed in the first pixel region PXA1, a second pixel circuit unit may be disposed in the second pixel region PXA2, and a third pixel circuit unit may be disposed in the third pixel region PXA3. Each of the first to third pixel circuit units may include eight transistors (e.g., the first to eighth transistors T1 to T8), and five capacitors (e.g., the storage capacitor Cst), the first and second node capacitors Cn1 and Cn2, and the first and second boost capacitors Cbst1 and Cbst2. The first to third pixel circuit units may have the same circuit configuration, and have similar layout structures.

According to an embodiment of the disclosure, one additional gate electrode T1_gate may be disposed in each of the first to third pixel regions PXA1, PXA2, and PXA3. The additional gate electrode T1_gate may correspond to a portion of the first node N1 illustrated in FIG. 5. The additional gate electrode T1_gate may be utilized to form the first and second boost capacitors Cbst1 and Cbst2, particularly, the additional gate electrode T1_gate may overlap the j-th compensating scan line GCLj to form the first sub-boost capacitor Cbst1, and overlap a second auxiliary scan line A_GCL to be described later to form the second sub-boost capacitor Cbst2. The second boost capacitor Cbst2 may include a first sub-boost capacitor Cbst21 and a second sub-boost capacitor Cbst22. The first sub-boost capacitor Cbst21 and the second sub-boost capacitor Cbst22 may be electrically connected to each other in series.

The first pixel circuit unit may be electrically connected to the first and second sub-light emitting elements ED_R1 and ED_R2 (see FIG. 4B), the second pixel circuit unit may be electrically connected to the second light emitting element ED_G (see FIG. 4B), and the third pixel circuit unit may be electrically connected to the third light emitting element ED_B (see FIG. 4B).

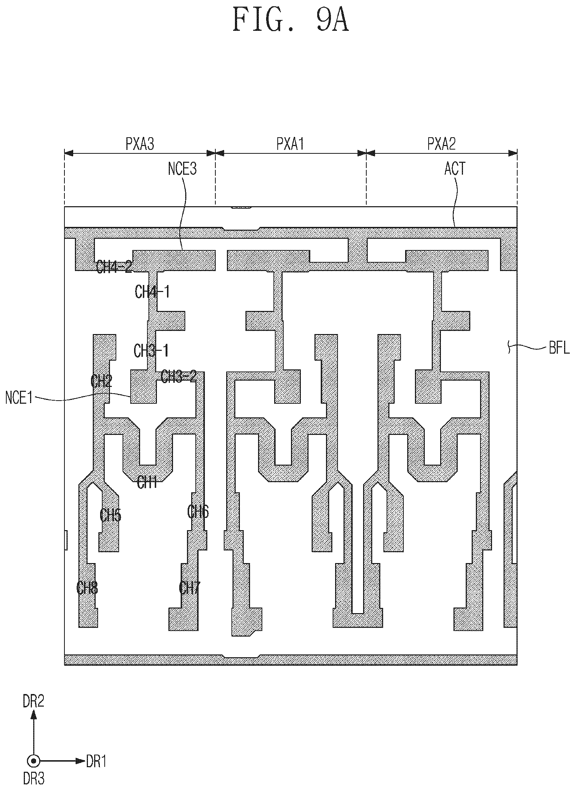

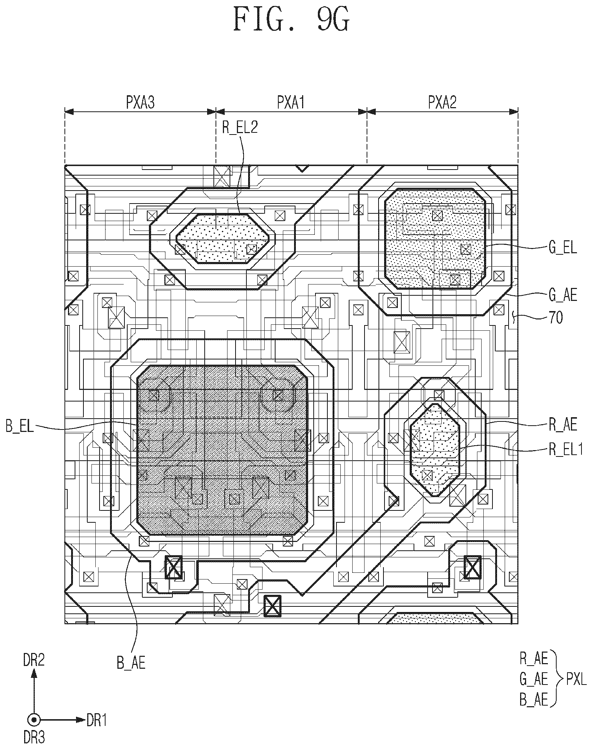

FIGS. 9A to 9G are schematic plan views illustrating the layout for each of layers stacked on a display panel. For example, FIG. 9A is a schematic plan view illustrating a semiconductor pattern layer disposed on a buffer layer, and FIG. 9B is a schematic plan view illustrating a first gate pattern layer disposed on a first insulating layer and a semiconductor pattern layer. FIG. 9C is a schematic plan view illustrating a second gate pattern layer disposed on a second insulating layer and a first gate pattern layer, and FIG. 9D is a schematic plan view illustrating a third gate pattern layer disposed on a third insulating layer and a second gate pattern layer. FIG. 9E is a schematic plan view illustrating a first data pattern layer disposed on a fourth insulating layer and a third gate pattern layer, and FIG. 9F is a schematic plan view illustrating a second data pattern layer disposed on a fifth insulating layer and a first data pattern layer. FIG. 9G is a schematic plan view illustrating an anode electrode layer disposed on a seventh insulating layer, and a second data pattern layer.

Referring to FIGS. 8 and 9A, a semiconductor pattern layer ACT may be disposed on the buffer layer BFL. The semiconductor pattern layer ACT may include a silicon semiconductor. For example, the silicon semiconductor may include amorphous silicon, or polycrystalline silicon. The semiconductor pattern layer ACT may include low-temperature polycrystalline silicon (LTPS).

The semiconductor pattern layer ACT may include semiconductor patterns of transistors (e.g., the first to eighth transistors T1 to T8) included in each of the first to third pixel circuit units. The semiconductor patterns may be electrically connected to each other integrally with each other.

The semiconductor pattern layer ACT may include the channel part CH1 of the first transistor T1, the channel part CH2 of the second transistor T2, the channel part CH3-1 of the first sub-transistor T3-1, the channel part CH3-2 of the second sub-transistor T3-2, and the first node capacitor electrode NCE1. The first node capacitor electrode NCE1 may be interposed between the channel part CH3-1 of the first sub-transistor T3-1 and the channel part CH3-2 of the second sub-transistor T3-2. The first node capacitor electrode NCE1 may correspond to the first coupling node GN1 of FIG. 5.

The semiconductor pattern layer ACT further may include the channel part CH4-1 of the third sub-transistor T4-1, the channel part CH4-2 of the fourth sub-transistor T4-2, and the third node capacitor electrode NCE3. The third node capacitor electrode NCE3 may be interposed between the channel part CH4-1 of the third sub-transistor T4-1, and the channel part CH4-2 of the fourth sub-transistor T4-2. The third node capacitor electrode NCE3 may correspond to the second coupling node GN2 of FIG. 5.

The semiconductor pattern layer ACT further may include the channel part CH5 of the fifth transistor T5, the channel part CH6 of the sixth transistor T6, the channel part CH7 of the seventh transistor T7, and the channel part CH8 of the eighth transistor T8. The semiconductor pattern layer ACT further may include the first and second electrodes S1 and D1 of the first transistor T1 to the first and second electrodes of the eighth transistor T8.

Referring to FIGS. 8 and 9B, the first insulating layer 10 may be disposed on the semiconductor pattern layer ACT, and the first gate pattern layer GAT1 may be disposed on the first insulating layer 10. The first gate pattern layer GAT1 may be formed by patterning the first gate metal layer. The first gate pattern layer GAT1 may include metal, an alloy, a conductive metal oxide, or a transparent conductive material. For example, the first gate pattern layer GAT1 may include silver (Ag), an alloy containing silver (Ag), molybdenum (Mo), an alloy containing molybdenum (Mo), aluminum (Al), an alloy containing aluminum (Al), aluminum nitride (AlN), tungsten (W), tungsten nitride (WN), copper (Cu), indium tin oxide (ITO), or indium zinc oxide (IZO), but embodiments of the disclosure are not limited thereto.

The first gate pattern layer GAT1 may include gate electrodes of transistors (e.g., the first to eighth transistors T1 to T8) included in the first to third pixel circuit units. The first to eighth transistors T1 to T8 of the pixel circuit units may be formed by the first gate pattern layer GAT1 and the semiconductor pattern layer ACT.

The first gate pattern layer GAT1 may include first to fourth auxiliary scan lines A_GIL, A_GCL, A_EML, and A_GBL, an auxiliary scan pattern A_GWP, and the first capacitor electrode CE1. Each of the first to fourth auxiliary scan lines A_GIL, A_GCL, A_EML, and A_GBL may extend in the first direction DR1 to overlap at least one of the first to third pixel regions PXA1, PXA2, and PXA3 in a plan view.

The first auxiliary scan line A_GIL may include the gate electrode G4-1 of the third sub-transistor T4-1, which overlaps the channel part CH4-1 of the third sub-transistor T4-1, and the gate electrode G4-2 of the fourth sub-transistor T4-2, which overlaps the channel part CH4-2 of the fourth sub-transistor T4-2. The second auxiliary scan line A_GCL may include the gate electrode G3-1 of the first sub-transistor T3-1, which overlaps with the channel part CH3-1 of the first sub-transistor T3-1, and the gate electrode G3-2 of the second sub-transistor T3-2, which overlaps the channel part CH3-2 of the second sub-transistor T3-2.

The auxiliary scan pattern A_GWP may be provided in the form of an island, and may include the gate electrode G2 of the second transistor T2, which overlaps the channel part CH2 of the second transistor T2. The first capacitor electrode CE1 may extend from the gate electrode G1 of the first transistor T1, which overlaps the channel part CH1 of the first transistor T1.

The third auxiliary scan line A_EML may include the gate electrode G5 of the fifth transistor T5, which overlaps the channel part CH5 of the fifth transistor T5, and the gate electrode G6 of the sixth transistor T6, which overlaps the channel part CH6 of the sixth transistor T6. The fourth auxiliary scan line A_GBL may include the gate electrode G7 of the seventh transistor T7, which overlaps the channel part CH7 of the seventh transistor T7, and the gate electrode G8 of the eighth transistor T8, which overlaps the channel part CH8 of the eighth transistor T8.

Referring to FIGS. 8 and 9C, the second insulating layer 20 may be disposed on the first insulating layer 10 to cover the first gate pattern layer GAT1. The second gate pattern layer GAT2 may be disposed on the second insulating layer 20. The second gate pattern layer GAT2 may be formed by patterning a second gate metal layer. The second gate pattern layer GAT2 may include metal, an alloy, a conductive metal oxide, or a transparent conductive material.

The second gate pattern layer GAT2 may include the second capacitor electrode CE2, the second and fourth node capacitor electrodes NCE2 and NCE4, a repair line RPL, and a (2-1)-th initializing voltage line VAIL _GB. The second capacitor electrode CE2 may be disposed to overlap the first capacitor electrode CE1 in a plan view. The storage capacitor Cst (see FIG. 7) may be formed by the first capacitor electrode CE1 and the second capacitor electrode CE2, in each of the first to third pixel regions PXA1 to PXA3.

The second node capacitor electrode NCE2 may branch off from the second capacitor electrode CE2 in the second direction DR2, and may be disposed to overlap the first node capacitor electrode NCE1 in a plan view. The first node capacitor Cn1 (see FIG. 7) may be formed by the first and second node capacitor electrodes NCE1 and NCE2, in each of the first to third pixel regions PXA1 to PXA3.

The fourth node capacitor electrode NCE4 may be disposed in the form of an island, and may be disposed to overlap the third node capacitor electrode NCE3 in a plan view. The second node capacitor Cn2 (see FIG. 7) may be formed by the third and fourth node capacitor electrodes NCE3 and NCE4, in each of the first to third pixel regions PXA1 to PXA3.

The repair line RPL may be provided to repair the lines (for example, the scan lines and the light emitting control lines) provided for the display panel DP (see FIG. 3). The repair line RPL may extend in a direction (for example, the first direction DR1) of extending the scan lines and the light emitting control lines. In case that one of the scan lines and the light emitting control lines is disconnected, two portions of the disconnected line are connected to the repair line RPL disposed adjacent to the two portions and thus electrically connected to each other by the repair line RPL. The repair line RPL may be electrically connected to the disconnected line in the non-display region NDA (see FIG. 3).

The second initializing voltage line VAIL illustrated in FIG. 5 may include a (2-1)-th initializing voltage line VAIL_GB electrically connected to the second and third pixels and a (2-2)-th initializing voltage line VAIL_R (see FIG. 9D) electrically connected to the first pixel. The (2-1)-th initializing voltage line VAIL_GB may supply a (2-1)-th initializing voltage to the second and third pixels, and the (2-2)-th initializing voltage line VAIL_R may supply a (2-2)-th initializing voltage to the first pixel. The (2-2)-th initializing voltage may have a voltage level different from a voltage level of the (2-1)-th initializing voltage. The (2-1)-th initializing voltage line VAIL_GB may be electrically connected to second electrodes of the seventh transistors T7 disposed in the second and third pixel regions PXA2 and PXA3.

Referring to FIGS. 8 and 9D, the third insulating layer 30 may be disposed on the second insulating layer 20 to cover the second gate pattern layer GAT2. The third gate pattern layer GAT3 may be disposed on the third insulating layer 30. The third gate pattern layer GAT3 may include metal, an alloy, a conductive metal oxide, or a transparent conductive material.

The third gate pattern layer GAT3 may include the additional gate electrode T1_gate, the light emitting control line EML, the bias voltage line VBL, and the (2-2)-th initializing voltage line VAIL_R. The additional gate electrode T1_gate may be disposed to overlap the first and second capacitor electrodes CE1 and CE2 in a plan view. The additional gate electrode T1_gate may be electrically connected to the gate electrode G1 of the first transistor T1 through the first contact hole CNT1, and electrically connected to the second electrode D3-1 (see FIG. 7) of the first sub-transistor T3 and the first electrode S4-1 (see FIG. 7) of the third sub-transistor T4 through the second contact hole CNT2.

The light emitting control line EML may overlap the third auxiliary scan line A_EML (see FIG. 9B) in a plan view, and may be electrically connected to the third auxiliary scan line A_EML through the contact hole. The light emitting control line EML may overlap the gate electrode G5 of the fifth transistor T5 and the gate electrode G6 of the sixth transistor T6 in a plan view.

The bias voltage line VBL may be electrically connected to the first electrode of the eighth transistor T8 to supply the bias voltage Vbias (see FIG. 5) to the eighth transistor T8. The (2-2)-th initializing voltage line VAIL_R may be electrically connected to the second electrode of the seventh transistor T7, which is disposed in the first pixel region PXA1, to supply the (2-2)-th initializing voltage to the seventh transistor T7 of the first pixel.

Referring to FIGS. 8 and 9E, the fourth insulating layer 40 may be disposed on the third insulating layer 30 to cover the third gate pattern layer GAT3. The first data pattern layer SD1 may be disposed on the fourth insulating layer 40. The first data pattern layer SD1 may be formed by patterning a first data metal layer. The first data pattern layer SD1 may include metal, an alloy, a conductive metal oxide, or a transparent conductive material.

The first data pattern layer SD1 may include the initializing scan line GIL, the compensating scan line GCL, the write scan line GWL, the black scan line GBL, the first initializing voltage line VIL, and the horizontal voltage line H_VL1. The initializing scan line GIL, the compensating scan line GCL, the write scan line GWL, the black scan line GBL, the first initializing voltage line VIL, and the horizontal voltage line H_VL1 may extend in the first direction DR1 and may be spaced apart from each other in the second direction DR2.

The initializing scan line GIL may overlap the first auxiliary scan line A_GIL in a plan view, and may be electrically connected to the first auxiliary scan line A_GIL (see FIG. 9B) through the contact hole. The compensating scan line GCL may overlap the second auxiliary scan line A_GCL (see FIG. 9B) in a plan view, and may be electrically connected to the second auxiliary scan line A_GCL through the contact hole. The write scan line GWL may overlap the auxiliary scan pattern A_GWP in a plan view, and electrically connected to the auxiliary scan pattern A_GWP through the contact hole. The black scan line GBL may overlap the fourth auxiliary scan line A_GBL in a plan view, and may be electrically connected to the fourth auxiliary scan line A_GBL (see FIG. 9B) through the contact hole.

As described above, in case that the first to fourth auxiliary scan lines A_GIL to A_GBL are disposed, even if each of the initializing scan line GIL, the compensating scan line GCL, the light emitting control line EML, and the black scan line GBL is disconnected, a signal may be applied through the first to fourth auxiliary scan lines A_GIL to A_GBL. Accordingly, a pixel defect may be minimized.

The first initializing voltage line VIL may be electrically connected to the second electrode D4-2 of the fourth sub-transistor T4-2, to supply the first initializing voltage Vint to the fourth sub-transistor T4-2. The horizontal voltage line H_VL1 may be included in the first driving voltage line VL1. The horizontal voltage line H_VL1 may be electrically connected to the second capacitor electrode CE2 (see FIG. 9C,) to supply the first driving voltage ELVDD to the second capacitor electrode CE2 of the storage capacitor Cst.

The first data pattern layer SD1 may include multiple connecting electrodes. Multiple connecting electrodes may include the first and second connecting electrodes CNE1 and CNE2.

Referring to FIGS. 8 and 9F, the fifth insulating layer 50 may be disposed on the fourth insulating layer 40 to cover the first data pattern layer SD1. The second data pattern layer SD2 may be disposed on the fifth insulating layer 50. The second data pattern layer SD2 may be formed by patterning a second data metal layer. The second data pattern layer SD2 may include, for example, metal, an alloy, a conductive metal oxide, or a transparent conductive material.

The second data pattern layer SD2 may include the data line DL, the vertical voltage line V_VL1, and a dummy vertical line EOAL.

The data line DL, the vertical voltage line V_VL1, and the dummy vertical line EOAL may extend in the second direction DR2, and may be spaced apart from each other in the first direction DR1. The data line DL may be electrically connected to the first electrode S2 (see FIG. 7) of the second transistor T2 though the first connecting electrode CNE1 (see FIGS. 7 and 9E). The data line DL may correspond to one of the data lines DL1 to DLm illustrated in FIG. 3.

The vertical voltage line V_VL1 may include a portion which overlaps the second capacitor electrode CE2 (see FIG. 9C) in a plan view. The vertical voltage line V_VL1 may be electrically connected to the horizontal voltage line H_VL1 through a contact hole formed through the fifth insulating layer 50. The first driving voltage line VL1 (see FIG. 5) may be formed, in the display panel DP, in a mesh shape by the horizontal voltage line H_VL1 illustrated in FIG. 9E and the vertical voltage line V_VL1 illustrated in FIG. 9F, Accordingly, the voltage drop of the first driving voltage ELVDD (see FIG. 5) supplied through the first driving voltage line VL1 may be prevented. Accordingly, the first driving voltage line VL1 may supply the first driving voltage ELVDD, which is uniform, to the pixels PX. Accordingly, the brightness difference between pixels resulting from the voltage drop of the first driving voltage ELVDD may be reduced. Accordingly, the image quality of the display panel DP may be improved as a whole.

The dummy vertical line EOAL may be electrically connected to at least one of the first initializing voltage line VIL, the bias voltage line VBL, the (2-1)-th initializing voltage line VAIL_GB, and the (2-2)-th initializing voltage line VAIL_R. The first initializing voltage line VIL, the bias voltage line VBL, the (2-1)-th initializing voltage line VAIL_GB, and the (2-2)-th initializing voltage line VAIL _R may be electrically connected to the dummy vertical line EOAL to be provided in a mesh shape in the display panel DP. Accordingly, the voltage drop of voltages supplied to the first initializing voltage line VIL, the bias voltage line VBL, the (2-1)-th initializing voltage line VAIL_GB, and the (2-2)-th initializing voltage line VAIL _R may be prevented. The dummy vertical line EOAL may be utilized as the second driving voltage line VL2 (see FIG. 5)

The second data pattern layer SD2 may further include the third connecting electrode CNE3. The third connecting electrode CNE3 may be provided in the form of an island in each of the first to third pixel regions PXA1 to PXA3, and may be electrically connected to the connecting signal line SCL (see FIG. 7) through the second connecting electrode CNE2 (see FIGS. 7 and 9E).

Referring to FIGS. 7 and 9G, the sixth insulating layer 60 may be disposed on the fifth insulating layer 50 to cover the second data pattern layer SD2. The anode electrode layer PXL may be disposed on the seventh insulating layer 70. The anode electrode layer PXL may include metal, an alloy, a conductive metal oxide, or a transparent conductive material.

The anode electrode layer PXL may include a first anode R_AE of the first and second sub-light emitting elements ED_R1 and ED_R2 (see FIG. 4B), a second anode G_AE of the second light emitting element ED_G, and a third anode B_AE of the third light emitting element ED _B. Each of the first to third anodes R_AE, G_AE, and B_AE may be disposed to overlap a relevant third connecting electrode CNE3 in a plan view. Each of the first to third anodes R_AE, G_AE, and B_AE may be electrically connected to the second connecting electrode CNE2 (see FIG. 7) and the connecting signal line SCL (see FIG. 7) through the relevant third connecting electrode CNE3.

The anode electrode layer PXL may be covered by the pixel defining layer PDL, and the opening OP (see FIG. 7) may be provided in the pixel defining layer PDL to expose the first to third anodes R_AE, G_AE, and B_AE.

The first sub-light emitting element ED_R1 further may include a first sub-light emitting layer R_EL1 disposed on the first anode R_AE, and the second sub-light emitting element ED_R2 further may include the second sub-light emitting layer R_EL2 disposed on the first anode R_AE. The second light emitting element ED_G further may include a second light emitting layer G_EL disposed on the second anode G_AE, and the third light emitting element ED_B further may include the third light emitting layer B_EL disposed on the third anode B_AE.

According to an embodiment of the disclosure, each of the first and second sub-light emitting layers R_EL1 and R_EL2 may be a red light emitting layer to output a red light, the second light emitting layer G_EL may be a green light emitting layer to output a green light, and the third light emitting layer B_EL may be a blue light emitting layer to output a blue light. Each of the first and second sub-light emitting layers R_EL1 and R_EL2 may have a hexagonal shape, and each of the second and third light emitting layers G_EL and B_EL may have an octagonal shape.

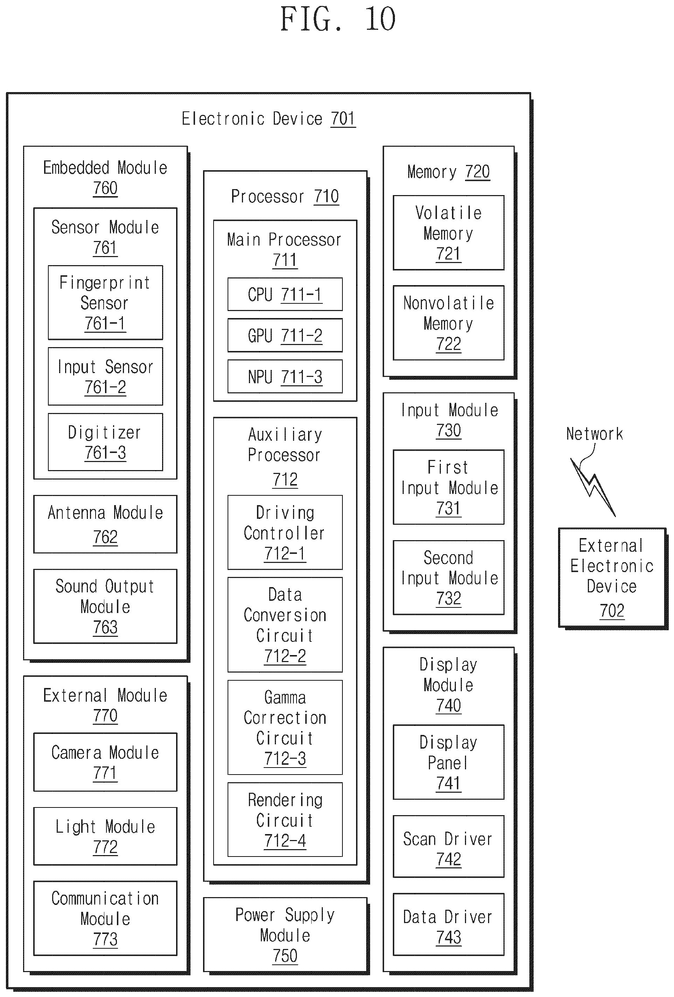

FIG. 10 is a schematic block diagram of an electronic device, according to an embodiment of the disclosure.

Referring to FIG. 10, an electronic device 701 may output various pieces of information through a display module 740 within an operating system. In case that a processor 710 executes an application stored in a memory 720, a display module 740 may provide application information to a user through a display panel 741.

The processor 710 may obtain an external input through an input module 730 or a sensor module 761 and may execute an application corresponding to the external input. For example, in case that the user selects a camera icon displayed on the display panel 741, the processor 710 may obtain a user input through an input sensor 761-2 and activate a camera module 771. The processor 710 may deliver image data corresponding to a captured image obtained through the camera module 771 to the display module 740. The display module 740 may display an image corresponding to the captured image through the display panel 741.

For another example, in case that personal information is authenticated on the display module 740, a fingerprint sensor 761-1 may obtain entered fingerprint information as input data. The processor 710 may compare input data obtained through the fingerprint sensor 761-1 with authentication data stored in the memory 720 and may execute an application based on the comparison result. The display module 740 may display information, which is executed based on the logic of the application, through the display panel 741.

For another example, in case that a music streaming icon displayed on the display module 740 is selected, the processor 710 may obtain a user input through the input sensor 761-2 and activate the music streaming application stored in the memory 720. In case that a music play command is input by the music streaming application, the processor 710 may provide sound information corresponding to the music play command to the user by activating a sound output module 763.

The operation of the electronic device 701 is briefly described above. Hereinafter, a configuration of the electronic device 701 will be described in detail. Some of components of the electronic device 701, which will be described below, may be integrated and provided as one configuration, or the one configuration may be provided to be separated into two or more configurations.

Referring to FIG. 10, the electronic device 701 may communicate with an external electronic device 702 through a network (e.g., a short-range wireless communication network or a long-range wireless communication network). The electronic device 701 may include the processor 710, the memory 720, the input module 730, the display module 740, a power supply module 750, an embedded module 760, and an external module 770. In the electronic device 701, at least one of the above-described components may be omitted, or one or more other components may be added. Some (e.g., the sensor module 761, an antenna module 762, or the sound output module 763) of the components described above may be integrated into another component (e.g., the display module 740).

The processor 710 may execute software to control at least another component (e.g., hardware or software component) of the electronic device 701 electrically connected to the processor 710, and may process and calculate various types of data. As at least part of data processing or calculation, the processor 710 may store instructions or data received from other components (e.g., the input module 730, the sensor module 761 or a communication module 773) into a volatile memory 721, may process instructions or data stored in the volatile memory 721. The result data may be stored in a nonvolatile memory 722.

The processor 710 may include a main processor 711 and an auxiliary processor 712. The main processor 711 may include one or more of a central processing unit (CPU) 711-1 or an application processor (AP). The main processor 711 may further include one or more of a graphic processing unit (GPU) 711-2, a communication processor (CP), and an image signal processor (ISP). The main processor 711 may further include a neural processing unit (NPU) 711-3. The NPU 711-3 may be a processor that is specialized in processing an artificial intelligence model. The artificial intelligence model may be generated through machine learning. The artificial intelligence model may include multiple artificial neural network layers. The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more of the networks, but may not be limited to the above-described example. In addition to a hardware structure, additionally or in another embodiment, the artificial intelligence model may include a software structure. At least two of the processing units and the processors that are described above may be implemented as one integrated component (e.g., a single chip) or may be implemented as independent components (e.g., multiple chips).

The auxiliary processor 712 may include a driving controller 712-1. The driving controller 712-1 may include an interface converting circuit and a timing control circuit. The driving controller 712-1 may receive an image signal from the main processor 711, converts the data format of the image signal so as to be suitable for the interface disclosures with the display module 740, and may output image data. The driving controller 712-1 may output various control signals required to drive the display module 740. The configuration of the driving controller 712-1 is substantially similar to the driving controller 100 shown in FIG. 3, and thus detailed descriptions are omitted to avoid redundancy.

The auxiliary processor 712 may further include a data converting circuit 712-2, a gamma correcting circuit 712-3, and a rendering circuit 712-4. The data converting circuit 712-2 may receive the image data from the driving controller 712-1 and may compensate for the image data such that an image is displayed at a desired luminance according to characteristics of the electronic device 701 or setting of the user or may convert the image data to reduce power consumption or compensate for afterimages. The gamma correcting circuit 712-3 may convert the image data, a gamma reference voltage, or the like such that the image displayed on the electronic device 701 has desired gamma characteristics. The rendering circuit 712-4 may receive the image data from the driving controller 712-1 and may render the image data in consideration of a pixel arrangement of the display panel 741 applied to the electronic device 701. At least one of the data converting circuit 712-2, the gamma correcting circuit 712-3, and the rendering circuit 712-4 may be integrated into another component (e.g., the main processor 711 or the driving controller 712-1). At least one of the data converting circuit 712-2, the gamma correcting circuit 712-3, and the rendering circuit 712-4 may be integrated into a data driver 743.

The memory 720 may store various pieces of data, which are used by at least one component (e.g., the processor 710 or the sensor module 761) of the electronic device 701 and input data or output data for commands related thereto. The memory 720 may include at least one or more of the volatile memory 721 and the nonvolatile memory 722.

The input module 730 may receive, from the outside (e.g., the user or an external electronic device 702) of the electronic device 701, commands or data to be used in a components (e.g., the processor 710, the sensor module 761, or the sound output module 763) of the electronic device 701.

The input module 730 may include a first input module 731, through which the commands or data are input from the user, and a second input module 732 through which the commands or data are input from the external electronic device 702. The first input module 731 may include a microphone, a mouse, a keyboard, a key (e.g., a button), or a pen (e.g., a passive pen or an active pen). The second input module 732 may support a designated protocol capable of being electrically connected to the external electronic device 702 by wire or wirelessly. The second input module 732 may include a high definition multimedia interface (HDMI), a universal serial bus (USB) interface, a secure digital (SD) card interface, or an audio interface. The second input module 732 may include a connector that may be physically connected to the external electronic device 702, for example, an HDMI connector, a USB connector, an SD card connector, or an audio connector (e.g., a headphone connector).

The display module 740 may provide visual information to the user. The display module 740 may include the display panel 741, a scan driver 742, and the data driver 743. The display module 740 may further include a window, a chassis, a bracket, or the like for protecting the display panel 741. The display module 740 may further include a light emitting driver, a voltage generator, and the like. The voltage generator may output various voltages (e.g., the first and second driving voltages ELVDD and ELVSS (see FIG. 3)) required to drive the display panel 741. The configuration of the display panel 741, the scan driver 742, the data driver 743, and the voltage generator may be substantially similar to the configuration of the display panel DP, the scan driver 300, the data driver 200, and the voltage generator 400 shown in FIG. 3, and thus detailed descriptions are omitted to avoid redundancy.

The power supply module 750 may supply power to the components of the electronic device 701. The power supply module 750 may include a battery that charges a power voltage. The battery may include a non-rechargeable primary cell, a rechargeable secondary cell, a fuel cell, or the like. The power supply module 750 may include a power management integrated circuit (PMIC). The PMIC may supply optimized power to the above-described modules and modules which will be described below. The power supply module 750 may include a wireless power transmission/reception member electrically connected to the battery. The wireless power transmission/reception member may include multiple coil-shaped antenna radiators.

The electronic device 701 may further include the embedded module 760 and the external module 770. The embedded module 760 may include the sensor module 761, the antenna module 762, and the sound output module 763. The external module 770 may include the camera module 771, a light module 772, and the communication module 773.

The sensor module 761 may detect an input from the user's body or an input from a pen among the first input module 731, and may generate an electrical signal or data value corresponding to the input. The sensor module 761 may include at least one of the fingerprint sensor 761-1, the input sensor 761-2, and a digitizer 761-3.

The fingerprint sensor 761-1 may generate a data value corresponding to a fingerprint of the user. The fingerprint sensor 761-1 may include one of an optical-type fingerprint sensor, or a capacitance-type fingerprint sensor.

The input sensor 761-2 may generate a data value corresponding to coordinate information of an input by a body of the user or an input by a pen. The input sensor 761-2 may generate the change in capacitance due to the input as the data value. The input sensor 761-2 may sense an input by a passive pen or may transmit or receive data to or from an active pen.

The input sensor 761-2 may measure a biometric signal such as blood pressure, moisture, or body fat. For example, in case that the user touches a part of the body to a sensor layer or sensing panel and does not move during a specific period, the input sensor 761-2 may detect the biometric signal and may output information desired by the user to the display module 740 based on a changes in electric fields caused by the part of the body.

The digitizer 761-3 may generate the data value corresponding to coordinate information of an input by the pen. The digitizer 761-3 may generate an electromagnetic change amount due to the input as the data value. The digitizer 761-3 may sense input by the passive pen or transmit or receive data to or from the active pen.

At least one of the fingerprint sensor 761-1, the input sensor 761-2, and the digitizer 761-3 may be implemented as a sensor layer formed on the display panel 741 through a subsequent process. The fingerprint sensor 761-1, the input sensor 761-2, and the digitizer 761-3 may be placed on the upper side of the display panel 741, and one (e.g., the digitizer 761-3) of the fingerprint sensor 761-1, the input sensor 761-2, and the digitizer 761-3 may be placed on the lower side of the display panel 741.

At least two or more of the fingerprint sensor 761-1, the input sensor 761-2, and the digitizer 761-3 may be formed to be integrated into one sensing panel through the same process. In case that being integrated into one sensing panel, the sensing panel may be placed between the display panel 741 and a window placed on the upper side of the display panel 741. The sensing panel may be placed on a window, and the location of the sensing panel is not particularly limited thereto.

At least one of the fingerprint sensor 761-1, the input sensor 761-2, and the digitizer 761-3 may be built into the display panel 741. For example, at least one of the fingerprint sensor 761-1, the input sensor 761-2, and the digitizer 761-3 may be simultaneously formed through a process of forming elements (e.g., a light emitting element, a transistor, or the like) included in the display panel 741.

The sensor module 761 may generate an electrical signal or a data value corresponding to the internal state or external state of the electronic device 701. For example, the sensor module 761 may further include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, or an illumination sensor.

The antenna module 762 may include one or more antennas to transmit or receive the signal or power to or from an external source. The communication module 773 may transmit or receive the signal to or from the external electronic device 702 through the antenna suitable for a communication method. An antenna pattern of the antenna module 762 may be integrated into the input sensor 761-2 or one component (e.g., the display panel 741) of the display module 740.

The sound output module 763 may be a device for outputting an audio signal to the outside of the electronic device 701 and, for example, may include a speaker used for general purposes, such as multimedia playback or recording playback, and a receiver used only for receiving a call. The receiver may be implemented separately from the speaker or may be integrated with the speaker. A sound output pattern of the sound output module 763 may be integrated into the display module 740.

The camera module 771 may shoot (or capture) a still image or a video image. The camera module 771 may include one or more lenses, an image sensor, or an image signal processor. The camera module 771 may further include an infrared camera capable of measuring the presence or absence of the user, a position of the user, a gaze of the user, or the like.

The light module 772 may provide light. The light module 772 may include a light emitting diode or a xenon lamp. The light module 772 may operate in conjunction with the camera module 771 or may operate independently from the camera module 771.

The communication module 773 may support establishing a wired or wireless communication channel between the electronic device 701 and the external electronic device 702 and performing communication through the established communication channel. The communication module 773 may include one or all of wireless communication modules such as a cellular communication module, a short-range wireless communication module, or a global navigation satellite system (GNSS) communication module, or wired communication modules such as a local area network (LAN) communication module or a power line communication module. The communication module 773 may communicate with the external electronic device 702 through a short-range communication network such as Bluetooth, WiFi direct, or infrared data association (IrDA) or a long-range communication network such as a cellular network, Internet, or a computer network (e.g., the LAN or a wide area network (WAN)). The above-mentioned various communication modules 773 may be implemented into one chip or may be respectively implemented into separate chips.

The input module 730, the sensor module 761, the camera module 771, and the like may be utilized to control an operation of the display panel 741 in conjunction with the processor 710.

The processor 710 may output commands or data to the display module 740, the sound output module 763, the camera module 771, or the light module 772 based on input data received from the input module 730. For example, the processor 710 may generate image data in response to input data applied through a mouse, an active pen, or the like to output the generated image data to the display module 740 or may generate command data in response to the input data to output the generated command data to the camera module 771 or the light module 772. In case that no input data is received from the input module 730 during a specific period, the processor 710 may switch an operation mode of the electronic device 701 to a low-power mode or a sleep mode to reduce power consumed in the electronic device 701.

The processor 710 may output commands or data to the display module 740, the sound output module 763, the camera module 771, or the light module 772 based on sensing data received from the sensor module 761. For example, the processor 710 may compare authentication data authorized by the fingerprint sensor 761-1 with the authentication data stored in the memory 720, and then may execute an application based on the comparison result. The processor 710 may execute commands or may output corresponding image data to the display module 740 based on sensing data sensed by the input sensor 761-2 or the digitizer 761-3. In case that the sensor module 761 may include a temperature sensor, the processor 710 may receive temperature data regarding the measured temperature from the sensor module 761 and may further perform luminance correction on image data based on the temperature data.

The processor 710 may receive measurement data regarding the presence or absence of the user, the user's location, and the user's gaze from the camera module 771. The processor 710 may further perform luminance correction on the image data based on the measurement data. For example, the processor 710 that determines the presence or absence of the user through an input from the camera module 771 may output image data, of which the luminance is corrected, to the display module 740 through the data converting circuit 712-2 or the gamma correcting circuit 712-3.

Some of the components may be electrically connected to each other through communication methods between peripheral devices, for example, a bus, a general purpose input/output (GPIO), a serial peripheral interface (SPI), a mobile industry processor interface (MIPI), or an ultra-path interconnect (UPI) link and may exchange a signal (e.g., commands or data) between each other. The processor 710 may communicate with the display module 740 through a mutually promised interface, and for example, may use any one of the above-described communication methods, and embodiments of the disclosure are not limited to the above-described communication methods.

The electronic device 701 according to various embodiments disclosed in the disclosure may be implemented with various types of devices. The electronic device 701 may include, for example, at least one of a portable communication device (e.g., a smart phone), a computer device, a portable multimedia device, a portable medical device, a camera, a wearable device, or a home appliance. The electronic device 701 according to an embodiment of this disclosure may not be limited to the above-described devices.

According to some embodiments of the disclosure, as the pixel circuit unit may include the first and second boost capacitors, even if the data voltage higher than the black data voltage (that is, the target voltage) is not supplied to the pixel circuit unit, the potential at the first node may be increased to the target voltage for the data write period specified through the boosting operation.

Accordingly, the data voltage higher than the target voltage needs not to be supplied to the pixel circuit unit to express the black grayscale value. Accordingly, the power consumption of the display device may be reduced.

As discussed, embodiments can provide a display device comprising: a display panel including a pixel, wherein the pixel includes: a light emitting element; a first transistor connected between the light emitting element and a first driving voltage line, wherein the first transistor is arranged to operate based on a potential at a first node; a second transistor connected between a data line and a first electrode of the first transistor, wherein the second transistor is arranged to receive a first scan signal through a first scan line; a third transistor connected between the first node and a second electrode of the first transistor, wherein the third transistor is arranged to receive a second scan signal through a second scan line; a fourth transistor connected between the first node and a first initializing voltage line, wherein the fourth transistor is arranged to receive a third scan signal through a third scan line; a storage capacitor connected between the first node and the first driving voltage line; a first boost capacitor connected between the first node and the first scan line; and a second boost capacitor connected between the first node and the second scan line.

The display panel may include an element layer including the light emitting elements of each pixel, and a circuit layer including a pixel circuit unit respectively connected to each light emitting element. The circuit layer may include the first to fourth transistors.

In some embodiments, the first transistor includes a gate electrode connected to the first node, a first electrode connected to a second node, and a second electrode connected to a third node.

In some embodiments, the second transistor including a gate electrode connected to the first scan line, a first electrode connected to the data line, and a second electrode connected to the second node.

In some embodiments, the third transistor includes a gate electrode connected to the second scan line, a first electrode connected to the third node, and a second electrode connected to the first node.

In some embodiments, the fourth transistor including a gate electrode connected to a third scan line, a first electrode connected to the first initializing voltage line, and a second electrode connected to the first node.

In some embodiments, the pixel comprises a first capacitor electrode that extends from the gate electrode of the first transistor, and a second capacitor electrode which faces the first capacitor electrode to form the storage capacitor.

In some embodiments, the pixel comprises an additional gate electrode connected to the gate electrode of the first transistor, and overlapping the first scan line to form the first boost capacitor.

In some embodiments, the additional gate electrode is disposed on a layer different from a layer for the gate electrode of the first transistor, the second capacitor electrode, and the first scan line.

In some embodiments, the pixel comprises a fifth transistor connected between the first electrode of the first transistor and the first driving voltage line. The fifth transistor may be arranged to receive a light emitting control signal through a light emitting control line connected to its gate.

In some embodiments, the pixel comprises a sixth transistor connected between the second electrode of the first transistor and the light emitting element. The sixth transistor may be arranged to receive the light emitting control signal through the light emitting control line connected to its gate.

In some embodiments, the pixel comprises a seventh transistor connected between the light emitting element and a second initializing voltage line. The seventh transistor may be arranged to receive a fourth scan signal through a fourth scan line connected to its gate.

In some embodiments, the pixel comprises an eighth transistor connected between the first electrode of the first transistor and a bias voltage line. The eighth transistor may be arranged to receive the fourth scan signal through the fourth scan line connected to its gate.

Embodiments can provide a display device comprising: an element layer including a light emitting element; and a circuit layer including a pixel circuit unit connected to the light emitting element, wherein the circuit layer includes: a first transistor including a gate electrode connected to a first node, a first electrode connected to a second node, and a second electrode connected to a third node; a second transistor including a gate electrode connected to a first scan line, a first electrode connected to a data line, and a second electrode connected to the second node; a third transistor including a gate electrode connected to a second scan line, a first electrode connected to the third node, and a second electrode connected to the first node; a fourth transistor including a gate electrode connected to a third scan line, a first electrode connected to a first initializing voltage line, and a second electrode connected to the first node; a first capacitor electrode extending from the gate electrode of the first transistor; a second capacitor electrode which faces the first capacitor electrode to form a storage capacitor, and connected to a first driving voltage line; and an additional gate electrode connected to the gate electrode of the first transistor, and overlapping the first scan line to form a first boost capacitor, and the additional gate electrode is disposed on a layer different from a layer for the gate electrode of the first transistor, the second capacitor electrode, and the first scan line.

In some embodiments, there is a second boost capacitor connected between the first node and the second scan line.

In some embodiments, there is a fifth transistor connected between the first electrode of the first transistor and the first driving voltage line. The fifth transistor may be arranged to receive a light emitting control signal through a light emitting control line connected to its gate.

In some embodiments, there is a sixth transistor connected between the second electrode of the first transistor and the light emitting element. The sixth transistor may be arranged to receive the light emitting control signal through the light emitting control line connected to its gate.

In some embodiments, there is a seventh transistor connected between the light emitting element and a second initializing voltage line. The seventh transistor may be arranged to receive a fourth scan signal through a fourth scan line connected to its gate.

In some embodiments, there is an eighth transistor connected between the first electrode of the first transistor and a bias voltage line. The eighth transistor may be arranged to receive the fourth scan signal through the fourth scan line connected to its gate.

Embodiments can provide an electronic device comprising: a display device according to any one of the above mentioned embodiments, a panel driver arranged to drive the display panel; and a main processor arranged to provide an image signal to the panel driver.

While the disclosure has been described with reference to embodiments thereof, it will be apparent to those of ordinary skill in the art that various changes and modifications may be made thereto without departing from the scope of the disclosure as set forth in the following claims.

## Claims

1. A display device comprising:
a display panel including a pixel,
wherein the pixel includes:
a light emitting element;
a first transistor connected between the light emitting element and a first driving voltage line, wherein the first transistor is arranged to operate based on a potential at a first node;
a second transistor connected between a data line and a first electrode of the first transistor, wherein the second transistor is arranged to receive a first scan signal through a first scan line;
a third transistor connected between the first node and a second electrode of the first transistor, wherein the third transistor is arranged to receive a second scan signal through a second scan line;
a fourth transistor connected between the first node and a first initializing voltage line, wherein the fourth transistor is arranged to receive a third scan signal through a third scan line;
a storage capacitor connected between the first node and the first driving voltage line;
a first boost capacitor connected between the first node and the first scan line; and
a second boost capacitor connected between the first node and the second scan line.

2. The display device of claim 1, wherein the second boost capacitor includes:
a first sub-boost capacitor and a second sub-boost capacitor connected in series between the first node and the second scan line.

3. The display device of claim 1 or 2, wherein the third transistor includes:
a first sub-transistor connected between the first node and a first coupling node, and the first sub-transistor that receives the second scan signal through the second scan line; and
a second sub-transistor connected between the first coupling node and the second electrode of the first transistor, and the second sub-transistor that receives the second scan signal through the second scan line.

4. The display device of claim 3, wherein the pixel further includes:
a first node capacitor connected between the first coupling node and the first driving voltage line.

5. The display device of any one of claims 1 to 4, wherein the fourth transistor includes:
a third sub-transistor connected between the first node and a second coupling node, wherein the third sub-transistor is arranged to receive a third scan signal through a third scan line; and
a fourth sub-transistor connected between the second coupling node and the first initializing voltage line, wherein the fourth sub-transistor is arranged to receives the third scan signal through the third scan line.

6. The display device of claim 5, wherein the pixel further includes:
a second node capacitor connected between the second coupling node and the first initializing voltage line.

7. The display device of any one of claims 1 to 6, wherein
the first scan signal is activated during a data write period,
the second scan signal is activated during a compensating period,
the data write period and the compensating period overlap each other,
each of the data write period and the compensating period is a low level period, and
a terminating time point of the compensating period is the same as or follows a terminating time point of the data write period.

8. The display device of any one of claims 1 to 7, wherein the pixel further includes:
a fifth transistor connected between the first electrode of the first transistor and the first driving voltage line, wherein the fifth transistor is arranged to receive a light emitting control signal through a light emitting control line;
a sixth transistor connected between the second electrode of the first transistor and the light emitting element, wherein the sixth transistor is arranged to receive the light emitting control signal through the light emitting control line;
a seventh transistor connected between the light emitting element and a second initializing voltage line, wherein the seventh transistor is arranged to receive a fourth scan signal through a fourth scan line; and
an eighth transistor connected between the first electrode of the first transistor and a bias voltage line, wherein the eighth transistor is arranged to receive the fourth scan signal through the fourth scan line, and
each of the first, second, third, fourth, fifth, sixth, seventh, and eighth transistors is a low-temperature polycrystalline silicon, LTPS, transistor.

9. A display device comprising:
an element layer including a light emitting element; and
a circuit layer including a pixel circuit unit connected to the light emitting element,
wherein the circuit layer includes:
a first transistor including a gate electrode connected to a first node, a first electrode connected to a second node, and a second electrode connected to a third node;
a second transistor including a gate electrode connected to a first scan line, a first electrode connected to a data line, and a second electrode connected to the second node;
a third transistor including a gate electrode connected to a second scan line, a first electrode connected to the third node, and a second electrode connected to the first node;
a fourth transistor including a gate electrode connected to a third scan line, a first electrode connected to the first node, and a second electrode connected to a first initializing voltage line;
a first capacitor electrode extending from the gate electrode of the first transistor;
a second capacitor electrode which faces the first capacitor electrode to form a storage capacitor, and connected to a first driving voltage line; and
an additional gate electrode connected to the gate electrode of the first transistor, and overlapping the first scan line to form a first boost capacitor, and
the additional gate electrode is disposed on a layer different from a layer for the gate electrode of the first transistor, the second capacitor electrode, and the first scan line.

10. The display device of claim 9, wherein the circuit layer further includes:
a first insulating layer;
a first gate pattern layer disposed on the first insulating layer, and including the gate electrodes of the first, second, third, and fourth transistors and the first capacitor electrode;
a second insulating layer arranged to cover the first gate pattern layer;
a second gate pattern layer disposed on the second insulating layer, and including the second capacitor electrode;
a third insulating layer arranged to cover the second gate pattern layer; and
a third gate pattern layer disposed on the third insulating layer, and including the additional gate electrode.

11. The display device of claim 10, wherein the circuit layer further includes:
an auxiliary scan line connected to the second scan line through at least two contact holes, and
the auxiliary scan line is disposed on the first insulating layer and included in the first gate pattern layer.

12. The display device of claim 11, wherein
the circuit layer further includes:
a fourth insulating layer arranged to cover the third gate pattern layer; and
a first data pattern layer disposed on the fourth insulating layer, and including the first, second, and third scan lines and a horizontal voltage line, and
the additional gate electrode overlaps the second scan line to form a first sub-boost capacitor, and overlaps the auxiliary scan line to form a second sub-boost capacitor.
optionally wherein the circuit layer further includes: a fifth insulating layer arranged to cover the first data pattern layer, and a second data pattern layer disposed on the fifth insulating layer, and including the data line and a vertical voltage line, and wherein the vertical voltage line is connected to the horizontal voltage line to form the first driving voltage line.

13. The display device of any one of claims 9 to 12, wherein the third transistor includes:
a first sub-transistor including a gate electrode connected to the second scan line, a first electrode connected to a first coupling node, and a second electrode connected to the first node; and
a second sub-transistor including a gate electrode connected to the second scan line, a first electrode connected to the third node, and a second electrode connected to the first coupling node;
optionally wherein the circuit layer further includes: a semiconductor pattern layer including channel parts of the first, second, third, and fourth transistors, and the first and second electrodes of the first, second, third, and fourth transistors, and the semiconductor pattern layer further includes a first node capacitor electrode corresponding to the first coupling node;
optionally wherein the circuit layer further includes: a first insulating layer arranged to cover the semiconductor pattern layer; a first gate pattern layer disposed on the first insulating layer, and including the gate electrodes of the first to fourth transistors and the first capacitor electrode; a second insulating layer arranged to cover the first gate pattern layer; a second gate pattern layer disposed on the second insulating layer, and including the second capacitor electrode and a second node capacitor electrode which branches from the second capacitor electrode and overlaps the first node capacitor electrode; a third insulating layer arranged to cover the second gate pattern layer; and a third gate pattern layer disposed on the third insulating layer, and including the additional gate electrode, and the additional gate electrode is a non-overlapping with the second node capacitor electrode in a plan view.

14. The display device of claim 9, wherein the fourth transistor includes:
a third sub-transistor including a gate electrode connected to the third scan line, a first electrode connected to the first node, and a second electrode connected to a second coupling node; and
a fourth sub-transistor including a gate electrode connected to the third scan line, a first electrode connected to the first initializing voltage line, and a second electrode connected to the second coupling node;
optionally wherein the circuit layer further includes a semiconductor pattern layer including channel parts of the first, second, third, and fourth transistors and the first and second electrodes of the first, second, third, and fourth transistors, and the semiconductor pattern layer further includes a third node capacitor electronde corresponding to the second coupling node;
optionally wherein the circuit layer further includes: a first insulating layer arranged to cover the semiconductor pattern layer; a first gate pattern layer disposed on the first insulating layer, and including the gate electrodes of the first, second, third, and fourth transistors and the first capacitor electrode; a second insulating layer arranged to cover the first gate pattern layer; a second gate pattern layer disposed on the second insulating layer, and including a fourth node capacitor electrode overlapping the third node capacitor electrode, and the second capacitor electrode; a third insulating layer arranged to cover the second gate pattern layer; and a third gate pattern layer disposed on the third insulating layer, and including the additional gate electrode, and wherein the additional gate electrode is a non-overlapping state with the fourth node capacitor electrode in a plan view.

15. An electronic device comprising:
a display device according to any one of claims 1 to 14;
a panel driver arranged to drive the display panel; and
a main processor arranged to provide an image signal to the panel driver.
